# EUROPEAN PATENT SPECIFICATION

(11) **EP 0 683 450 B1**
(45) Date of publication and mention of the grant of the patent: **02.07.2003**
(21) Application number: 95106453.4
(22) Date of filing: 28.04.1995
(51) Int. Cl.: G06F 1/18, H05K 5/02

(54) **Card type semiconductor device**
Kartenartige Halbleiteranordnung
Dispositif semi-conducteur du type carte

(30) Priority: 06.05.1994 JP 11609994; 06.05.1994 JP 11610094; 21.02.1995 JP 5519295
(43) Date of publication of application: 22.11.1995
(73) Proprietor: SEIKO EPSON CORPORATION, Shinjuku-ku, Tokyo 163-0811 (JP)
(72) Inventor: Hashimoto, Nobuaki, c/o Seiko Epson Corp., Suwa-shi, Nagano-ken, 392 (JP); Nakamura, Norio, c/o Seiko Epson Corp., Suwa-shi, Nagano-ken, 392 (JP); Suemori, Hiroyuki, c/o Seiko Epson Corp., Suwa-shi, Nagano-ken, 392 (JP); Sugai, Hiroshi, c/o Seiko Epson Corp., Suwa-shi, Nagano-ken, 392 (JP); Imaoka, Norio, c/o Seiko Epson Corp., Suwa-shi, Nagano-ken, 392 (JP); Noake, Kazuyoshi, c/o Seiko Epson Corp., Suwa-shi, Nagano-ken, 392 (JP)
(74) Representative: Hoffmann, Eckart, Dipl.-Ing.

(56) References cited:
- EP-A- 0 552 042
- DE-A- 4 329 335
- US-A- 5 335 145
- US-A- 5 481 432

## Description

### BACKGROUND OF THE INVENTION

### 1. Field of The Invention

This invention relates to a plug-in card type semiconductor device, in which electronic components such as an integrated circuit (IC) chip and an large-scale integrated (LSI) circuit are mounted on a printed circuit board. Incidentally, such a semiconductor device can be incorporated into various industrial equipments and consumer-oriented equipments as a card-like small computer on which a central processing unit (CPU) and an IC for controlling peripheral equipment are mounted.

### 2. Description of The Related Art

Previously, with the advance of microcomputer technology, electronic control systems using computers have been widely employed in the field of consumer-oriented equipments such as communication equipment and audio and video equipments in addition to the field of various industrial equipments such as an automatic machine tool, an automobile, medical and industrial control systems, a vending machine and an automatic cash dispenser. Generally, a high proportion of computer systems incorporated in such equipments are dedicated systems, each of which is designed and manufactured on the basis of the uses, functions and design of such an equipment and diverse operating conditions of peripheral devices so as to be most suitable for such an equipment. Therefore, such a conventional computer system has drawbacks in that the development and manufacturing of the system cost much labor and take much time and that the manufacturing cost of the system increases. In contrast, regarding the architecture of the computer system, a specific architecture, for example, IBM PC/AT becomes a substantial standard. Most of peripheral devices conforming to such a standard can be shared among the computer systems.

Thus, there has been proposed an electronic apparatus as described in the specification of the Japanese Patent Application No. 5-278643/1993. In this electronic apparatus, a computer system to be incorporated into an equipment is changed into a unit system by enclosing the computer system in a compact card-like housing, for the purpose of realizing a general purpose computer system in terms of the shape and structure thereof. Thereby, the trouble and time required for designing and manufacturing a computer system corresponding to each equipment can be saved. Moreover, the cost can be reduced. Usually, such an electronic apparatus is formed by mounting a CPU, a memory, ICs for controlling input/output peripheral devices and the like on a printed circuit board. Further, a flexibility of hardware can be obtained by unifying the size, the shape and so forth of each of the printed circuit board and the card-like housing for enclosing it.

On the other hand, the miniaturization, reduction in weight, decrease in thickness and increase in performance of various electronic equipment have been rapidly promoted. Especially, in the field of computer technology, with dramatic increase in information content, the speed-up of information processing is demanded. Therefore, the development of various packaging techniques for connecting electronic components, together with the reduction in thickness of a printed circuit board, the decrease in pattern size, the employment of a multilayer structure and the miniaturization of electronic components, has been performed. For example, the surface mounting techniques for implementing IC packages such as a quad flat package (QFP) by utilizing a reflow soldering and the bare chip packaging techniques for implementing ICs by utilizing chip on board (COB) and tape automated bonding (TAB) methods are widely employed.

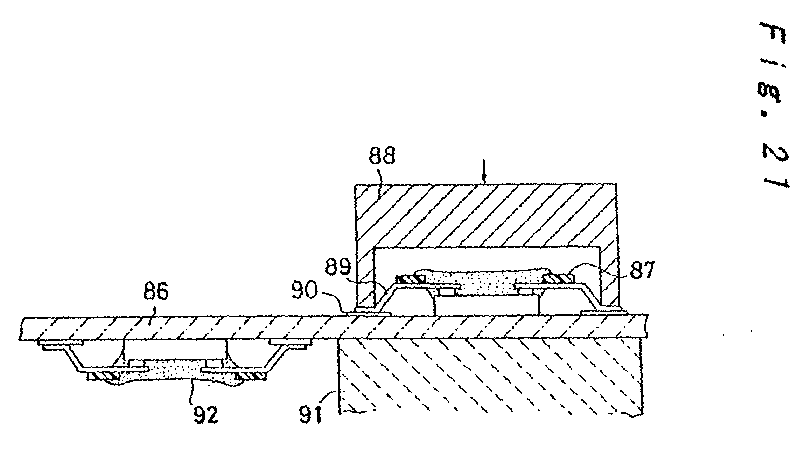

Especially, a tape carrier package (TCP) implemented by the TAB method excels in mass-productivity because the TCP can be connected to a printed circuit board with one operation regardless of the number of electrodes and leads. Moreover, the TCP is characterized in that the lead pitch thereof can be narrowed and that the TCP can be used for a large-chip high-pin-count device. Thus, the TCP is suitable for a high density packaging. Generally, in the case where a TCP is mounted on a printed circuit board, a method illustrated in FIG. 21 is performed. Namely, the TCP 87 to be mounted is first put on the printed circuit board 86. Then, outer leads 89 of the TCP 87 are pressed upon lands 90 provided on the printed circuit board 86 by using a bonding tool 88 lowered from above the TCP 87. If necessary, the outer leads 89 are simultaneously heated. Subsequently, the outer leads 89 are connected thereto by soldering or by performing a thermocompression or the like. At that time, the bonding tool 88 presses joint portions therebetween with a pressure of 10 kgf (98 N) or so. Thus, the printed circuit board should be placed on the flat top surface of a pedestal 91 and also should be sufficiently supported by the pedestal 91 from the back surface thereof.

However, in the cases of designing and manufacturing a computer system by using the unit electronic apparatus, it is necessary to suitably establish the performance such as the operating speed and memory capacity of each of semiconductor devices to be mounted in the system according to the functions and operating conditions required by an equipment or a facility, into which the system is incorporated. Further, in the case of, for example, a control system for an automatic machine tool or the like, it becomes necessary to rewrite data, which is stored therein, according to alterations of an object to be machined and of machining conditions and correspondingly to change in model of the tool to be used. Therefore, if the printed circuit board is redesigned or the entire circuit board is changed even when the system can keep up with the technological advances only by changing the memory capacity thereof, the system can not take full advantage of the flexibility or versatility thereof obtained as a result of being constituted as a unit system.

Further, in the case of performing the aforementioned conventional mounting method, when mounting a plurality of TCPs on both sides of a printed circuit board, respectively, a part of the TCPs are first mounted on one of the top and bottom surfaces of the printed circuit board. Thereafter, the remaining TCPs are mounted on the other of the top and bottom surfaces thereof. At that time, the printed circuit board 86, however, should be placed on the pedestal 91 in such a manner as to prevent the TCPs 92 earlier connected to the one of the top and bottom surfaces of the board 86 from touching the pedestal 91. Thus, the TCP 87 to be connected to the other of the top and bottom surfaces of the printed circuit board 86 can not be placed thereon just in back of the TCP 92 earlier connected to the opposite surface thereof. As a result, the areas of both of the top and bottom surfaces of the printed circuit board can not be effectively utilized. Thus, it becomes difficult to miniaturize the semiconductor device. Consequently, the conventional mounting method has encountered a problem that the density of the electronic components such as TCPs can not be sufficiently increased.

Especially, in the case of using a multilayer printed circuit board, usually, through holes are bored in the circuit board and further electrode terminals of TCPs are connected to the interconnecting lines of an internal layer circuit. However, in the case of the aforementioned conventional mounting method, there is a limit to the extent to which a plurality of ICs operating depending upon one another can be closely arranged on the circuit board. If such ICs are located apart from one another on a printed circuit board and are connected to both of a power supply line and a grounding line via through holes separately bored therein, undesirable differences and variations in power supply potentials of such ICs and a grounding potential may occur. Thus, the stability of an operation of the system may be degraded. Moreover, in the case where the number of the through holes is large, the area of the used circuit board becomes large. As a result, it becomes more difficult to miniaturize a circuit board and semiconductor devices. The conventional mounting method can not meet the needs of miniaturizing electronic equipment. Additionally, the lengths of interconnecting lines becomes long. Consequently, a desired high-speed operation can not be expected.

Furthermore, with the progress of the high-density packaging of a printed circuit board, heat generated in each IC is increased. Therefore, from the viewpoint of an ensuring of the durability of a circuit board and the stability of an operation of the system, it is very important to efficiently dissipate the generated heat. If heat dissipating means such as a radiation fin and a heat sink or a liquid cooling apparatus is used for that purpose, the cost is increased. In addition, the size of the entire circuit board becomes large. Consequently, it becomes more difficult to miniaturize semiconductor devices and equipments provided with such semiconductor devices.

The present invention is accomplished to resolve the problems of the conventional device and method.

Accordingly, an object of the present invention is to provide a plug-in card type semiconductor device which has sufficient flexibility or versatility ensured by forming the basic configuration thereof as a unit to thereby reduce the cost thereof, and also has adaptability to a special purpose, which is the ability to easily adapt to different functional requirements and operating conditions in a short time, especially, ability to easily change the memory capacity thereof.

In addition, reduction in size and thickness of a printed circuit board has been required to meet demands for forming the entire device as a compact unit. Especially, in the case where thermosetting protective resin for protecting IC chips is applied to a circuit board to which bare IC-chips are connected at a high density, a deformation such as a warp may appear in the circuit board after the protective resin has set. Therefore, another object of the present invention is to provide a plug-in card type semiconductor device having a structure in which a thin circuit board is resistant to deform.

Moreover, as the result of reduction in size and thickness of the entire device, it becomes necessary to ensure sufficient strength and durability of the device for handling the device in a field. Hence, a further object of the present invention is to provide a plug-in card type semiconductor device having a sufficiently strong and durable structure, by which the entire device can be compact.

Furthermore, with the progression of the down-sizing and performance improvement of computer systems, the high-density packaging and the reduction in size of patterns formed on the circuit board have been fostered. Moreover, the power consumption thereof can be saved or reduced. As a consequence, the semiconductor device becomes susceptible to the influence of external noises and that of radiation noises of a circuit thereof. Especially, operations of analog circuit portions such as a floppy disk drive unit, an analog-to-digital (AD) converter and a phase-locked loop (PLL) may become unstable under the influence of variation in power supply potentials of digital circuit portions.

Thus, still another object of the present invention is to provide a plug-in card type semiconductor device which can eliminate the fear of a malfunction by decreasing the influence of the noises, especially, upon the analog circuit portions and can ensure the stability and reliability of operations thereof.

Further, yet another object of the present invention is to provide a method for manufacturing a semiconductor device, which can relatively easily manufacture a plug-in card type semiconductor device having both of the flexibility and the adaptability to a special purpose without making a considerable change in a conventional process and increasing the cost.

Furthermore, a still further object of the present invention is to provide a plug-in card type semiconductor device suitable for a high density package and reduction in size, in which a plurality of package type IC components to be mounted on both of the top and bottom surfaces of a printed circuit board can be arranged in such a manner that the IC components mounted on one of the top and bottom surfaces of the printed circuit board are positioned thereon right in back of the IC components mounted on the opposite surface thereof, whereby the area of the surfaces of the circuit board can be efficiently utilized and the degrees of freedom in designing a circuit can be increased.

In addition, another object of the present invention is to provide a plug-in card type semiconductor device which can increase the operating speed thereof and can improve the stability and reliability thereof by reducing the lengths of interconnecting lines, especially, among IC chips operating largely depending upon one another.

Further, an additional object of the present invention is to provide a plug-in card type semiconductor device provided with a heat dissipating structure, which can effectively dissipate heat produced in the IC chips by performing a relatively simple method without using expensive heat dissipating means and a cooling device and can meet the demand for reduction in size of the device at a low cost, in addition to the arrangement of a plurality of package type IC components mounted on both of the top and bottom surfaces of a printed circuit board in such a manner that the IC components mounted on one of the top and bottom surfaces of the printed circuit board are placed thereon right in back of the IC components mounted on the opposite surface thereof.

### SUMMARY OF THE INVENTION

These objects are achieved with a plug-in card type semiconductor device as claimed.

In accordance with a first aspect of the present invention, at least the memory capacity can be easily changed according to change in model of an equipment, into which the semiconductor device is incorporated, and according to change in operating conditions by maintaining the modules of the main circuit board but replacing only the sub-circuit-board with another package. Moreover, a large number of models, which are different in memory capacity from one another, can be easily manufactured in a short time at a low cost by using the same general-purpose main circuit board. Furthermore, if it becomes necessary due to the advance of the technology and the alteration of operating conditions to change the memory capacity, the memory can be easily changed. Further, the semiconductor device can meet the demand for changing in the memory capacity, at a low cost, by still using the main circuit board. Especially, in the case where the CPU and the memory are mounted on the sub-circuit-board, the main circuit board is used in common. Further, wiring design is more flexible. The manufacturing of the semiconductor device can be facilitated. Moreover, the cost can be decreased. Additionally, the design of the CPU and the memory can be easily changed according to the required specific performance and the specific purpose by maintaining the basic performance of the semiconductor device. Consequently, the adaptability to a special purpose of the semiconductor device can be realized at a low cost.

In the case of a second example of the semiconductor device according to the first aspect of the present invention, the CPU is mounted on the main circuit board.

Thus, only the memory capacity of the semiconductor device can be easily changed by maintaining the performance of the main circuit board but replacing the sub-circuit-board with another package.

In contrast, in the case of a third example of the semiconductor device according to the first aspect of the present invention, the CPU is mounted on the sub-circuit-board.

Thus, the performance and the memory capacity of the semiconductor device can be easily changed, if necessary, by forming the basic configuration of the main board in such a manner as to be able to be used in common for various purposes and by replacing the sub-circuit-board with another package.

In the case of a fourth example of the semiconductor device according to the first aspect of the present invention, the main circuit board and the sub-circuit-board are connected with each other through a flexible printed circuit.

Thus, both of the boards can be easily connected by a flexible printed circuit at a low cost.

In contrast, in the case of a fifth example of the semiconductor device according to the first aspect of the present invention, the main circuit board and the sub-circuit-board are detachably connected with each other through a pair of connectors in such a manner that the main circuit board and the sub-circuit-board face each other.

Thus, a large number of connection terminals can be provided at a narrow pitch by using a connector. Further, the semiconductor device can relatively easily adapt to increase in number of the interconnecting lines, which is caused due to change in the memory and/or the CPU mounted on the sub-circuit-board.

In the case of a sixth example of the semiconductor device according to the first aspect of the present invention, in addition to the characteristic features of the fourth example thereof, the sub-circuit-board is placed in such a manner as to face the main circuit board by bending the flexible printed circuit. Further, the flexible printed circuit is connected to a surface of the main circuit board, which is opposite to another surface thereof facing the sub-circuit-board.

Thus, the flexible printed circuit can be bent at a larger curvature.

Moreover, a seventh example of the semiconductor device according to the first aspect of the present invention is further provided with means for integrally fixing the main circuit board and the sub-circuit-board, which face each other.

Thus, both of the boards can be fixed in such a manner as to prevent the relative position of the boards from being moved due to, for example, vibration during using the device. Moreover, electrical connection therebetween can be secured by preventing unnecessary stress from being exerted upon the flexible printed circuit and the connector.

In the case of an eighth example of the semiconductor device according to the first aspect of the present invention, in addition to the characteristic features of the first example thereof, the semiconductor device is further provided with a card-shaped thin housing for enclosing the main circuit board and the sub-circuit-board therein. Further, at least a surface of the housing is made of a metal plate outwardly protruded by drawing.

Thus, the rigidity sufficient to prevent an occurrence of deformation in the direction of thickness of a card-shaped thin housing can be imparted thereto by protruding a metal plate outwardly.

In addition, loads imposed upon the flexible printed circuit or the connector can be reduced by integrally fixing the main circuit board and the sub-circuit-board facing each other. Thereby, the durability against an external force due to vibration and shock can be improved. Consequently, reduction in size and thickness of the entire device can be achieved. Furthermore, to prepare for an unexpected accident during using the device, sufficient rigidity can be obtained by forming a side surface portion of the card-shaped housing for enclosing the device by use of a metal plate processed by drawing. Further, the thickness of the device can be further reduced.

In the case of a ninth example of the semiconductor device according to the first aspect of the present invention, the semiconductor device is further provided with a connector in which a large number of terminals to be connected to an external apparatus are arranged. Moreover, two of the terminals are a dot clock signal terminal to be connected to an external liquid crystal display (LCD) and a grounding terminal adjacent to the dot clock signal terminal.

Thus, a dot clock signal to be outputted to an external LCD can be stabilized. Consequently, a display of an image in the LCD can be stabilized.

In the case of a tenth example of the semiconductor device according to the first aspect of the present invention, the semiconductor device is further provided with a connector in which a plurality of rows of a large number of terminals to be connected to an external apparatus are arranged. Moreover, three of the terminals of one of the plurality rows are an R-signal terminal, a G-signal terminal and a B-signal terminal which are connected to an external CRT. Furthermore, three of the terminals of another of the plurality rows, which is parallel to the one of the plurality rows, are an R-retum-signal terminal, a G-return-signal terminal and a B-return-signal terminal which correspond to the R-signal terminal, the G-signal terminal and the B-terminal, respectively, and are placed at positions facing the R-signal terminal, the G-signal terminal and the B-signal terminal, respectively.

Thus, the influence of external noises or the like can be lowered by making the circumstances of the red, green and blue signals, which are analog signals to be outputted to an external CRT, become nearly the same as those of the corresponding return signals. Consequently, a display of an image on the CRT can be stabilized.

Additionally, the size of the entire device can be reduced. Further, the power consumption thereof can be saved. Thereby, the external electromagnetic influence can be lowered. Consequently, the quality of a display of an image in the LCD or on the CRT can be maintained at high level. Moreover, the stability and reliability of an operation of the device can be improved.

In the case of an eleventh example of the semiconductor device according to the first aspect of the present invention, the semiconductor device is further provided with a connector in which a large number of terminals to be connected to an external apparatus are arranged. The connector has means for dividing a row of the terminals into horizontally asymmetric portions arranged along the row.

Thus, the connector is adapted to be able to be connected to an equipment only in a direction. Consequently, there is no fear that the card type computer is fitted to the equipment in an erroneous direction.

In the case of a twelfth example of the semiconductor device according to the first aspect of the present invention, the semiconductor device is further provided with a second sub-circuit-board mounted on a surface of the main circuit board. An analog circuit part is mounted on the second sub-circuit-board. Moreover, a power supply terminal of the second sub-circuit-board is connected to a place of the main circuit board.

Thus, the influence of variation in power supply potential of a digital circuit part can be reduced and a space in the board can be saved by forming an analog circuit portion of the semiconductor device as a circuit board separated from the digital circuit part and by unifying the power supplies thereof.

In accordance with a second aspect of the present invention, there is provided a semiconductor device which comprises a plurality of electronic components mounted on circuit boards. The circuit boards are a main circuit board and a plurality of sub-circuit-boards, on each of which the electronic components are mounted. Moreover, at least two of the plurality of sub-circuit-boards are mounted on both of opposite surfaces of the main circuit board in such a manner that a positions of one of the sub-circuit-boards, which is mounted on one of the opposite surfaces of the main circuit board, and a position of another of the sub-circuit-boards, which is mounted on a surface of the main circuit board opposite to the one of the opposite surface thereof, are symmetric with respect to the main circuit board.

Thus, semiconductor devices, which have same size and shape but are different in functions from one another, can be relatively easily obtained at a low cost in a short time by mounting different electronic components on a plurality of sub-circuit-boards, respectively, and then selecting one or more of such a sub-circuit-boards and mounting the selected sub-circuit-boards on the main circuit board. Moreover, even if warpage occurs in a sub-circuit-board due to a small thickness thereof, deformation of the main circuit board can be effectively prevented by respectively connecting two sub-circuit-boards to positions, which are symmetric with respect to the main circuit board, on opposite surfaces thereof. Additionally, reduction in size and thickness of the entire device can be achieved.

In accordance with a third aspect of the present invention, there is provided a method for manufacturing a semiconductor device, in which a plurality of electronic components are mounted on circuit boards, which comprises the step of mounting the electronic components on a subcircuit board and the step of placing the sub-circuit-board at a predetermined position on a main circuit board, and then detachably tentatively attaching the sub-circuit-board to the main circuit board and thereafter connecting the sub-circuit-board to the main circuit board.

Thus, even if warpage takes place in a sub-circuit-board due to a small thickness thereof, the sub-circuit-board can be securely positioned and further connected to the main circuit board. Moreover, the device yield can be increased. The semiconductor device can be manufactured without considerably changing the conventional manufacturing process and without increasing the trouble and the cost.

In accordance with a first example of a fourth aspect of the present invention, the semiconductor device has a first IC package and a second IC package mounted on a first surface and a second surface of the main circuit board, respectively. The semiconductor device comprises a first connection portion for connecting a lead of the first IC package with a first land formed on the first surface and a second connection portion for connecting a lead of the second IC package with a second land formed on the second surface. The first surface is opposite to the second surface. Moreover, the first IC package and the second IC package are placed in such a manner that the second connection portion provided on the second surface is just in back of the first connection portion provided on the first surface.

Thus, the horizontal sections of the connection portions of the IC packages mounted on the opposite surfaces of the main circuit board can be overlapped in a plan view of the semiconductor device. Thereby, the wiring area can be reduced by the overlapped area. Moreover, the area of each of the opposite surfaces of the circuit board can be effectively utilized. Moreover, the wiring length between the IC packages corresponding to the connection portions, the horizontal sections of which are overlapped, can be reduced.

In the case of a second example of the semiconductor device according to the fourth aspect of the present invention, the second connection portion provided correspondingly to a side of the second IC package is just in back of the first connection portion provided correspondingly to a corresponding side of the first IC package.

Thus, the wiring area of the circuit board can be reduced by the overlapped area between the horizontal sections of the connection portions.

In the case of a third example of the semiconductor device according to the fourth aspect of the present invention, the second connection portion provided correspondingly to each of all of four sides of the second IC package is just in back of the first connection portion provided correspondingly to a corresponding one of all of four sides of the first IC package.

Thus, the wiring area of the circuit board can be considerably reduced by placing the IC packages in such a manner that the horizontal sections of the IC packages completely coincide with each other in a plan view of the semiconductor device.

In the case of a fourth example of the semiconductor device according to the fourth aspect of the present invention, the first and second IC packages are equipped with IC chips which operate in conjunction with one another.

Thus, for example, a power supply lead and a grounding lead of each IC package are placed in such a manner as to be close to the corresponding leads of other IC packages. Thereby, the wiring length between the IC packages can be shortened. Moreover, a through hole can be used in common among the IC packages.

Further, in the case of a fifth example of the semiconductor device according to the fourth aspect of the present invention, the first IC package is equipped with a CPU. Moreover, the second IC package is equipped with an I/O system which operates in response to the CPU.

Thus, the number of signal lines and address lines, which can be used in common among the IC packages, is large. Further, the number of necessary through holes can be considerably reduced by using the through holes in common among the IC packages.

Additionally, the high density packaging can be realized. Further, an operation of the device can be performed at a high speed. Moreover, the stability and reliability of an operation thereof can be improved by eliminating the fear of a malfunction.

In the case of a sixth example of the semiconductor device according to the fourth aspect of the present invention, the first IC package or the second IC package is a tape carrier package.

Thus, especially, in the case of the TCP, a wire or lead can be inwardly drawn from the connection (or bonding) portion on the circuit board in the regions of the outer leads and the carrier tape between the IC components mounted on the TCP. Further, through holes can be bored in such a region.

In accordance with a first example of a fifth aspect of the present invention, the semiconductor device comprises a first IC package and a second IC package. The first IC package and the second IC package are mounted on both of opposite surfaces of a printed circuit board in such a manner that the second IC package is just in back of the first IC package. The first IC package and the second IC package are connected to the opposite surfaces of the printed circuit board, respectively, through a die bonding. Moreover, the first IC package and the second IC package are thermally connected to each other through a via hole bored through the printed circuit board in such a manner that heat is able to be transferred between the first IC package and the second IC package.

Thus, a part of heat can be transferred from one of the first and second packages, which generates more heat than the other, to the other thereof through a via hole and the transferred heat can be then dissipated therefrom. Consequently, the heat dispersion area can be substantially increased without using expensive heat dissipating means and cooling devices. Moreover, a heat dissipating structure suitable for the miniaturization of the device can be obtained at a low cost.

In the case of a second example of the semiconductor device according to the fifth aspect of the present invention, leads of the first IC package and the second IC package respectively mounted on the opposite sides of the printed circuit board are coated with a thermally conductive resin.

Thus, heat generated by the IC package, which is transferred through the lead, can be dissipated from the thermally conductive resin which covers the lead of the connection (or bonding) portion.

### BRIEF DESCRIPTION OF THE DRAWINGS

Other features, objects and advantages of the present invention will become apparent from the following description of preferred embodiments with reference to the drawings in which like reference characters designate like or corresponding parts throughout several views, and in which:
- FIG. 1: is a schematic perspective view of a semiconductor device for use in a card type computer, which is a first embodiment of the present invention;
- FIG. 2: is a sectional view of the semiconductor device taken on line II-II of FIG. 1;
- FIG. 3: is a sectional view of a modification of the first embodiment of the present invention, similarly as in the case of FIG. 2;
- FIGS. 4A and 4B: are sectional diagrams for illustrating a mounting process of the first embodi- ment of the present invention;
- FIG. 5: is a sectional view of a second example of a printed circuit board of the present invention;
- FIGS. 6A and 6B: are sectional diagrams for illustrating a mounting process of the second example of the printed circuit board of the present invention;
- FIG. 7: is a perspective view of a card type housing for enclosing the semiconductor device which is the first embodiment of the present invention;
- FIG. 8: is a sectional view of a structure for connecting a main circuit board (hereunder sometimes referred to simply as a main board) with a sub-circuit-board (hereunder sometimes referred to simply as a sub-board), taken on line VIII-VIII of FIG. 7;
- FIG. 9: is a sectional view of another example of the structure for connecting the main board with the sub-board;
- FIG. 10: is a sectional view of a further example of the structure for connecting the main board with the sub-board;
- FIG. 11: is a sectional view of a still another example of the structure for connecting the main board with the sub-board;
- FIG. 12: is a sectional diagram for illustrating the structure of a card type housing;
- FIGS. 13A to 13C: are sectional diagrams for illustrating a process for manufacturing a second sub-board;
- FIGS. 14A to 14E: are diagrams for illustrating a process for connecting the second and third boards to both of the top and bottom surfaces of the main board, respectively, step by step;
- FIGS. 15A and 15B: are perspective diagrams schematically illustrating the main board and the first sub-board of the semiconductor device which is the second embodiment of the present invention, respectively;
- FIG. 16: is a partially enlarged diagram for illustrating a state in which a main board and a first sub-board of the second embodiment of the present invention;
- FIG. 17: is a diagram for illustrating the terminal or pin assignment or configuration of a first portion of a connector, which is divided or partitioned by a rib thereof;
- FIG. 18: is a diagram for illustrating the pin assignment or configuration of a half part of a second portion of the connector, which is divided by a rib thereof;
- FIG. 19: is a diagram for illustrating the pin assignment or configuration of the remaining half part of the second portion of the connector, which is divided by a rib thereof;
- FIG. 20: is a diagram for illustrating the pin assignment or configuration of a third portion of the connector, which is divided by a rib thereof; and
- FIG. 21: is a sectional diagram for illustrating a double-sided board mounting in a conventional semiconductor device.

### DETAILED DESCRIPTION OF THE PREFERRED EMBODIMENTS

Hereinafter, the preferred embodiments of the present invention will be described in detail by referring to the accompanying drawings.

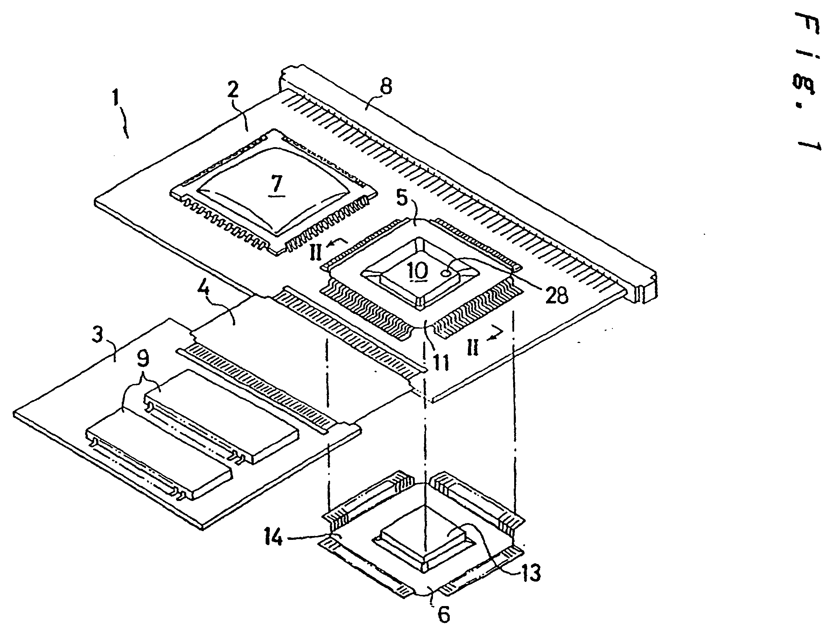

FIG. 1 schematically illustrates a semiconductor device to which the present invention is applied, namely, a first embodiment of the present invention. This semiconductor device 1 is used as a card-type small computer of nearly identical shape with what is called an IC card or a memory card or the like. Further, the semiconductor device 1 consists of two printed circuit boards each using a ceramic material or a glass epoxy material as a base material, namely, a main board 2, which has a multilayered structure for a double-sided board mounting, and a first sub-board 3 which is smaller than the main board 2. These boards are electrically connected to each other through a flexible printed circuit (FPC) 4 soldered to a longitudinal side of each of these boards. Further, a first TCP 5 is connected to the surface, onto which the FPC is connected, of the main board 2. Moreover, a second TCP 6 is connected to a position on the opposite surface of the main board 2 in such a manner that the positions of the TCPs 5 and 6 are symmetric with respect to the main board 2 and further the connection or land part attached to each of the four sides of the TCP 6 is placed just under the connection part attached to a corresponding one of the four sides of the TCP 5, as viewed in this figure.

Furthermore, thin printed circuit boards, on which electronic components are preliminarily mounted as will be described later, namely, a second sub-board 7 and a third sub-board (not shown) are respectively connected to both surfaces of the main board 2 in such a manner that these boards are mounted beside the TCPs 5 and 6, respectively, and the positions of these boards are symmetric with respect to the main board 2 and the second sub-board 7 is placed just above the third sub-board. Preliminarily, a plurality of different packages, which are equipped with different electronic components respectively corresponding to the different functions of the semiconductor device 1, are prepared for the second and third sub-boards. Further, a large number of kinds of the semiconductor devices 1, which are different in function and use from one another, can be designed and made at a low cost in a short time by suitably selecting and combining such packaged sub-boards. Moreover, the specifications can be relatively easily changed by replacing the second or third sub-board with another package. Furthermore, the main board 2 is equipped with electronic components (not shown), which are necessary for constituting primary modules of a computer system other than a main memory, in addition to the aforementioned electronic components. Additionally, a connector 8 for connecting the semiconductor device to an external apparatus is provided along the long side thereof opposite to the side to which the FPC 4 of the main board 2.

On the other hand, two random access memories (RAMs) 9 are mounted on the first sub-board 3 as memory elements constituting a main memory of the semiconductor device 1. Therefore, it is convenient to connect the FPC 4 to a part in the vicinity of the first TCP 5 of the main board 2. In the case of this embodiment, the memory capacity of each RAM 9 is 4 Mbits. Thus, the total memory capacity of the main memory is 8 Mbits. However, the memory capacity of the main memory can be appropriately altered by changing the capacity of the RAM or the number of the RAMs composing the main memory. The memory capacity of the main memory can be easily changed at a low cost in a short time by maintaining the modules of the main board 2 but replacing only the first sub-board 3 with another package.

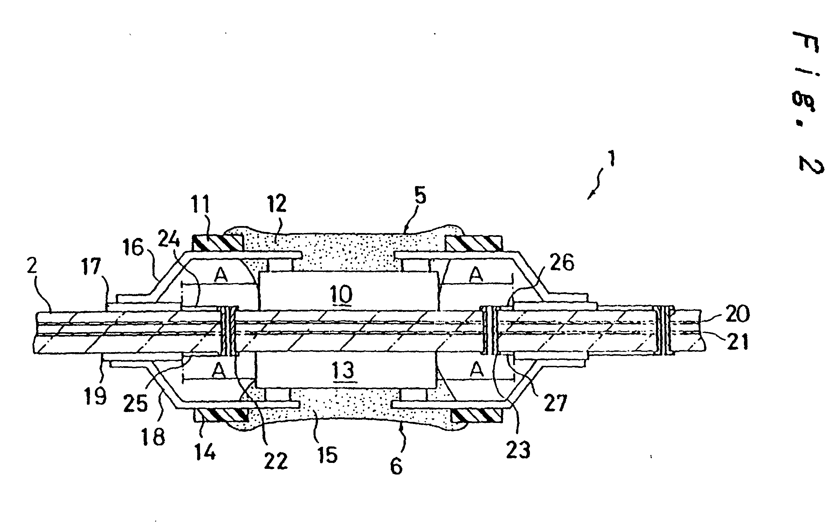

As shown in this figure and FIG. 2, the first TCP 5 is a nearly square thin IC package having a surface coated with a protective resin 12, in which the CPU 10 of the card-type computer is incorporated into the central opening of a tape carrier 11. On the other hand, the second TCP 6 is a thin IC package of nearly identical shape and size with the first TCP. Further, in the second TCP 6, an I/O sub-system chip 13 is incorporated into the central opening of a tape carrier 14. Moreover, the surface of the second TCP 6 is coated with a protective resin 15. As is well illustrated in FIG. 2, a large number of outer leads 16 are formed along the four sides of the first TCP 5 in such a manner as to extend outwardly therefrom. Further, the first TCP 5 is electrically connected to corresponding terminal areas 17 (referred to as "lands" hereinafter) formed on the top surface of the main board 2 by soldering the outer leads 16 thereto as will be described later. Similarly, the second TCP 6 is electrically connected to corresponding lands 19 formed on the bottom surface of the main board 2 by soldering the outer leads 16 formed along the four sides thereof to the lands 19.

Here, the lands 19 provided on the bottom surface of the main board 2 are almost just in back of the lands 17 provided on the top surface thereof. Further, the connection portion (namely, the bonding portion) between the outer leads 18 and the lands 19, which corresponds to each of the four sides of the TCP 6 mounted on the bottom surface of the board 2, is almost right in back of the connection portion between the outer leads 16 and the corresponding lands 17, which corresponds to a corresponding one of the four sides of the TCP 5 mounted on the top surface of the board 2. Therefore, the second TCP 6 is placed in such a manner that the horizontal section of the second TCP 6 would be seen as almost completely coinciding with the horizontal section of the first TCP 5 in a plan view of the semiconductor device 1. Thus, a part, the top and bottom surfaces of which are surrounded by the peripheries of and the connection portions corresponding to the chips 10 and 13, namely, a part, which is constituted only by the tape carrier, of the board 2 is obtained as a region A, on which interconnecting lines can be drawn, by mounting the TCPs 5 and 6 on the top and bottom surfaces of the main board 2, respectively, in such a manner that the chip 13 and the connection portions corresponding to the TCP 6 are placed just behind the chip 10 and the corresponding connection portions corresponding to the TCP 5, respectively. In the region A, the interconnecting lines can be drawn inwardly from the connection portions to the TCPs 6 and 5 and moreover, through holes can be bored.

In the case of this embodiment, the main board 2 has a multilayered structure consisting of six layers. As illustrated in this figure, a power supply line 20 and a grounding line 21, which are common to the CPU 10 and the I/O sub-system chip 13, and various signal lines are provide in internal layers of the main board 2. Further, common through holes 22 and 23 connected to the common power supply line 20 and grounding line 21 are bored through the region A of the main board 2. The power supply terminals of the CPU 10 and the I/O sub-system chip 13 are connected to the common power supply line 20 through the interconnecting lines 24 and 25 extending inwardly from the connection portions and through the common through hole 22. Moreover, similarly, the grounding terminals of the CPU 10 and the I/O sub-system chip 13 are connected to the common grounding line 21 through the interconnecting lines 26 and 27 extending inwardly from the connection portions and through the common through hole 23. Furthermore, other terminals of both of the TCPs are appropriately connected to predetermined signal lines by way of through holes or via holes (not shown).

In contrast with this, in the case where the two TCPs are mounted on the top and bottom surfaces of the board 2 in such a manner that the horizontal section of one of these TCPs would be seen as overlapping with or as being completely separated from the horizontal section of the other of these TCPs in a plan view of the semiconductor device 1, no through holes can be bored in regions of the board 2, on which the lands corresponding to the TCPs are formed, and on which the chips are placed. Therefore, the area of the surface of a part, in which a through hole is not bored, of the entire circuit board is increased. Thus, the area of both of the top and bottom surfaces of the circuit board can not be effectively utilized. Consequently, the size of the entire circuit board becomes large. In accordance with the present invention, in the case of each of the TCPs, an interconnecting pattern can be drawn from each of the four sides to the inside of the connection portions and can be connected to an internal layer by providing a through hole in the board. Thereby, the density of electronic components mounted on the circuit board is increased. Moreover, the effective utilization of the area of the circuit board can be achieved. Furthermore, the degrees of freedom in interconnecting-pattem design is increased.

Further, similarly as in the cases of the CPU and the I/O system chip, two IC chips, which operate largely depending upon each other, can be made to be substantially equal to each other in power supply potential and grounding potential by placing the two IC chips on the front and back surfaces of the same circuit board in such a fashion that one of the two IC chips is located just in back of the other thereof, and by using the power supply line and the grounding line in common to the two IC chips. Thus the stability of an operation of the semiconductor device can be improved. Moreover, for instance, the through hole 22 for power supply can be provided in the neighborhood of the connection portion between the power supply lead and the land. Furthermore, each of other through holes can be provided in the vicinity of the connection portion between the corresponding lead and land. Consequently, the wiring length of the interconnecting line drawn between the IC chips can be reduced. Additionally, an operating speed can be further increased by decreasing inductance and impedance. Further, capacitance between adjacent interconnecting lines decreases. Thus the influence of noises becomes small. Consequently, the fear of a malfunction is obviated.

Especially, in the case of the card type computer of this embodiment, a microprocessor "80386SL" manufactured by Intel Corporation of the United States of America is employed as the CPU 10. Further, another microprocessor "82360SL" manufactured by Intel Corporation is employed as the I/O sub-system chip 13. Usually, a small mark representing the position of a first pin is put at the nearer left (namely, lower left) corner of the top (namely, front) surface, on which characters representing the name of a manufacturer and a model designation are positionally correctly printed, of an IC chip, when viewed from the front of the chip. In the case of this embodiment, both of the chips "80386SL" and "82360SL" are placed in such a manner that the first pins indicated by reference numeral 28 in FIG. 1 are located at the nearer left corner when viewed from a position above the connector 8. In the case where both of the chips are mounted on the board in such a manner as to be symmetric with respect to the board similarly as in the case of this embodiment, leads respectively connected with the symmetrical positions of the chips are sometimes drawn therefrom. Especially, in the case where multi-bit (for instance, 16-bit or 32-bit) buses are respectively drawn therefrom, a lead from one of the chips and a corresponding lead from the other of the chips are often drawn to a common position on a plan view of the device. In the case of this embodiment, with the aforementioned placement of the chips, most of pins connected with one of the chips can be made to respectively face to corresponding pins connected with the other of the chips across the board 2. Thus, the number of a minimum set of through holes can be considerably reduced. Thereby, the area of the surface of a part, which is required for boring the through holes, of the circuit board can be decreased by about 20 %. Simultaneously, the stability and reliability of an operation of the device can be improved by reducing the wiring length between the upper and lower chips.

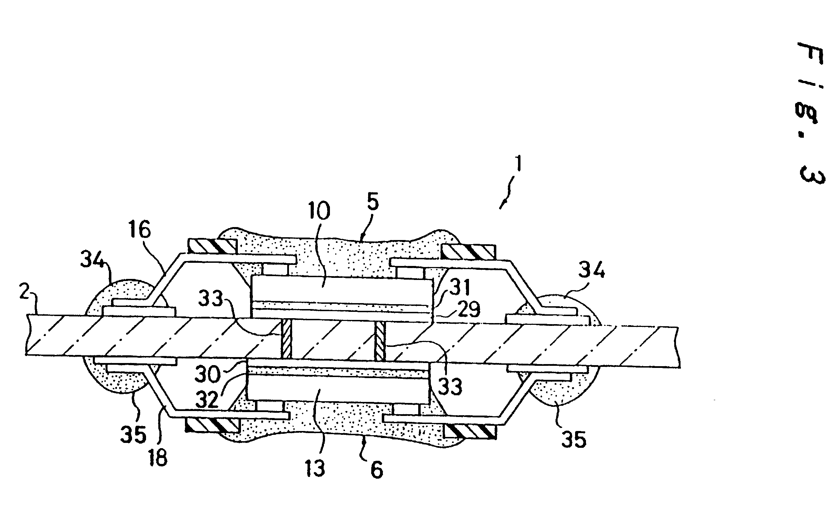

Referring to FIG. 3, there is shown a section of an example of a modification of the first embodiment of the present invention. In the case of this example of the modification, die pads 29 and 30, whose dimensions respectively correspond with those of the CPU 10 and the I/O sub-system chip 13 to be mounted thereon, are placed at predetermined locations on the top and bottom surfaces of the main board 2, respectively. Both of the chips are connected to the die pads 29 and 30 by applying thermally conductive resins 31 and 32 such as silver paste onto the entire bottom surfaces of the chips. A plurality of via holes 33 for heat transfer are bored through the main board 2. Thereby, the die pads 29 and 30 are connected with each other in such a manner as to transfer heat therebetween. When operating the card-type computer, the CPU 10 generates relatively high heat. In contrast, heat generated by the I/O sub-system chip 13 is relatively low. Therefore, a part of heat generated by the CPU 10 is transferred to the die pad 30 on the opposite surface of the board 2 through the thermally conductive resin layer 31, the die pad 29 and the via hole 33. Thereafter, the transferred heat is dissipated from the I/O sub-system chip 13. Further, a part of heat to be transferred through the via hole 33 is dissipated through the internal circuit of the main board 2.

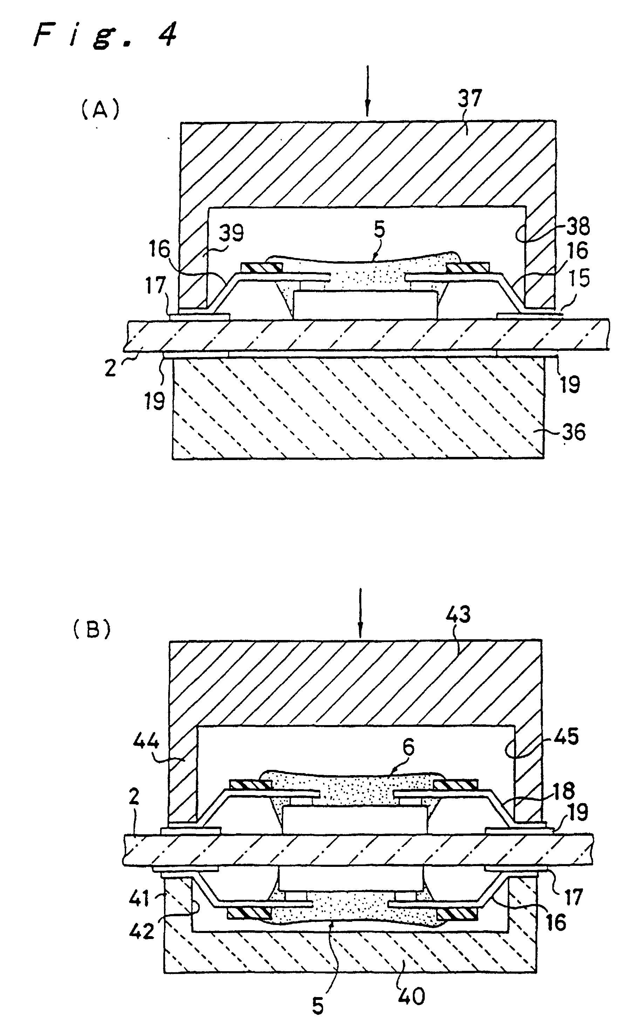

Furthermore, in the case of the embodiment of FIG. 3, insulating resins 34 and 35 for protection are applied to each of the connection portions between each of the outer leads 16 and the corresponding land 17 of the first TCP 5 and the connection portion between each of the outer leads 18 and the corresponding land 19 of the second TCP 6. The insulating resins have thermal conductivity. Therefore, heat generated by the CPU 10 is dissipated from the insulating resin 34 through the outer lead 16 of the first TCP and also dissipated from the insulating resin 35 through the outer lead 18 of the second TCP. Thus, highly exothermic devices can be mounted on the board at a high density without using expensive heat dissipating means and a cooling device by increasing the heat dissipating area. Simultaneously, the manufacturing cost can be reduced. Hereunder, a process for mounting the two TCPs 5 and 6 on both of the top and bottom surfaces of the main board 2 similarly as in the case of the first embodiment will be described by referring to FIGS. 4A and 4B. First, the first TCP 5 is connected to the top surface of the main board 2 by performing a method as illustrated in FIG. 4A, which is similar to a conventional method. The outer leads 16 of each of the four sides of the first TCP 5 are adjusted to corresponding lands 17 and are placed at a predetermined position on the main board 2. This board is put on a first pedestal 36, which has a flat top surface similarly as in the case of the conventional device, in such a way as to contain the area of the lands 17. Incidentally, a solder layer is preliminarily adhered onto the surface of each of the lands 17.

Next, a bonding tool 37 is lowered from a position thereof above the first TCP 5. A pressing portion 39 having a horizontal substantially rectangular shaped section like a character "□". which corresponds to the connection portions between the outer leads 16 and the lands 17, is formed by providing a rectangular recess portion 38 in the central part of the bottom portion of the bonding tool 37. The pressing portion 39 pushes the tips of the outer leads 16 respectively corresponding to the four sides of the TCP against the top surfaces of the lands 17 at a time.

Simultaneously, the connection portions between the outer leads 16 and the lands 17 are heated. The first TCP 5 fairly protrudes from the top surface of the main board 2 . However, almost all portions of the outer leads 16 are enclosed in the recess portion 38 excepting the tips thereof to be connected to the lands. Therefore, the protruded TCP 5 does not interfere with this pressing step at all. After the connection portions cool off, the bonding tool 37 is lifted and is thus separated from the outer leads 16. Thereby, each of the outer leads 16 is completely connected to the corresponding land 17 by soldering.

Subsequently, as illustrated in FIG. 4B, the main board 2 is turned upside down. Then, the second TCP 6 is mounted on the main board 2. Similarly, each of the outer leads 18 respectively corresponding to the four sides of the second TCP 6 is positioned by being adjusted to the corresponding land 19. This board is put on a second pedestal 40. The second pedestal 40 has a periphery supporting portion 41, the horizontal section of which is substantially rectangular shaped like a character "□" corresponding to the bottom surface of the aforementioned bonding tool 37. Thereby, the second pedestal 40 supports the main board 2 at the connection portions between the outer leads 16 and the lands 17. Parts of the first TCP 5 other than such connection portions are enclosed in a rectangular recess portion 42 formed in the central part of the top portion of the second pedestal 40. A solder layer is preliminarily adhered onto the surface of each of the lands 19.

Next, a bonding tool 43 is lowered from a position thereof above the second TCP 6. The bonding tool 43 has a similar shape to that of the bonding tool 37. Namely, the bonding tool 43 has a pressing portion 44, the horizontal section of which is substantially rectangular shaped like a character "□", and a central recess portion 45 in the bottom portion thereof. If the positions, shapes and sizes of the connection portions corresponding to the second TCP 6 are the same as those of the connection portions corresponding to the first TCP 5, the bonding tool 37 may be used as the bonding tool 43. The tips of all of the outer leads 18 respectively corresponding to the four sides of the second TCP 6 are connected at a time to the top surfaces of the lands 19 by pushing the tips of the outer leads 18 against the top surfaces of the corresponding lands 17 and simultaneously heating the connection portions between the outer leads 18 and the lands 19. Thus the main board 2 is supported and pressed between a periphery supporting portion 41 and a corresponding pressing portion 44, each of which has a horizontal section substantially rectangular shaped like a character "□", by using the second pedestal 40 and the bonding tool 43. Thereby, the two TCPs can be mounted at positions, which almost coincide with each other in a plan view of the device, on both of the top and bottom surfaces of the board, respectively, without being hindered by the TCP earlier connected to the board.

In the case of the aforementioned embodiment, two TCPS having a nearly the same size are used. However, in the case where two TCPs, which are different in size from each other, are mounted on the board in such a manner that the horizontal sections of the TCPs would be overlapped with each other in a plan view of the semiconductor device, it is natural that the smaller TCP is connected to one of the top and bottom surface of the board earlier than the larger TCP. Subsequently, the larger TCP is connected to the opposite surface of the board by using a larger pedestal which can cover the connection portions corresponding to the larger TCP.

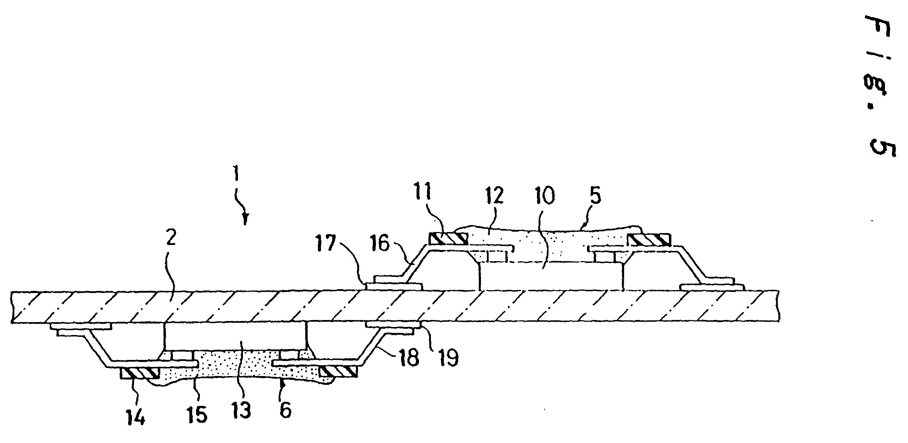

FIG. 5 schematically illustrates a second example of the printed circuit board to which the present invention is applied. In the case of the second embodiment, the first TCP 5 and the second TCP 6 are mounted on both of the top and bottom surfaces of the main board 2, respectively, in such a manner that only the horizontal section of the outer lead 16 corresponding to a side of the first TCP 5 would overlap with the horizontal section of the outer lead 18 corresponding to a corresponding side of the second TCP 6 in the horizontal section of the connection portion therebetween in a plan view of the board 2. Even in the case where in the layout of the circuit board, for some reason, both of the TCPs can not be placed in such a manner that the horizontal sections thereof would be seen as almost completely coinciding with each other in a plan view of the semiconductor device 1, the areas of both of the top and bottom surfaces of the circuit board can be effectively used and the high density package can be achieved by overlapping the horizontal sections of a part of the connection portions corresponding to one of the TCPs with the horizontal sections of a part of the connection portions corresponding to the other of the TCPs in a plan view of the semiconductor device. Especially, a common through hole can be bored in the main board 2 close to both of the outer lead 16, which corresponds to the one of the sides of the first TCP 5, and the outer lead 18, which corresponds to the corresponding side of the second TCP 6, the horizontal sections of which would overlap with each other in that of the corresponding connection portion in a plan view of the semiconductor device 1. Thus, the wiring length between elements or devices respectively provided in the first and second TCPs 5 and 6 can be decreased. Consequently, the operating speed can be increased. Simultaneously, in this case, needles to say, the influence of noises due to the wiring or interconnecting pattern can be decreased. Moreover, the stability and reliability of an operation can be improved.

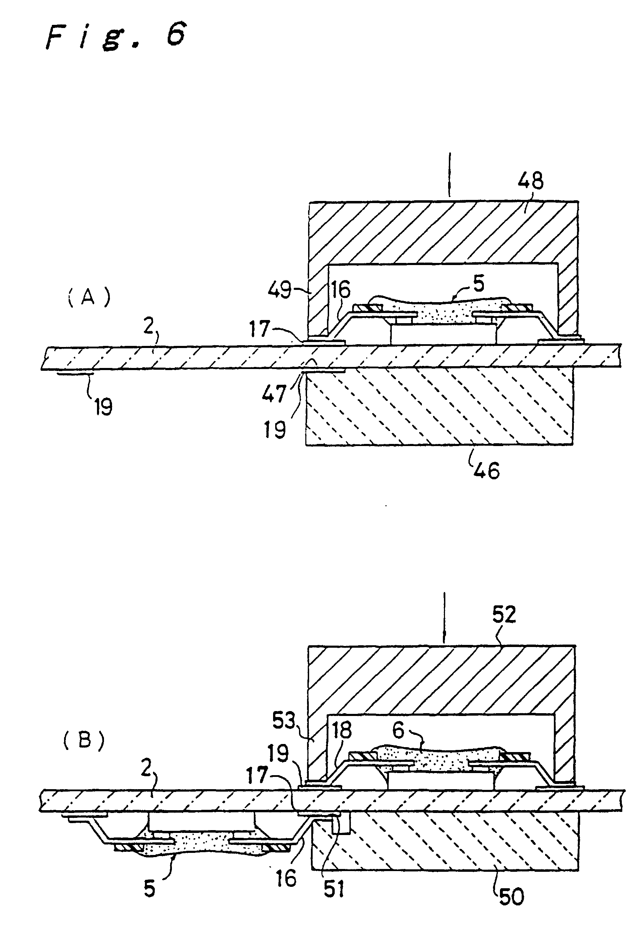

In the case of the printed circuit board of the second example, the two TCPs 5 and 6 can be mounted on both of the top and bottom surfaces of the main board 2 by following a process illustrated in FIGS. 6A and 6B. First, as illustrated in FIG. 6A, the first TCP 5 is placed on the surface of the main board 2 by adjusting the outer leads 16 of each of the four sides of the first TCP 5 to the corresponding lands 17. This main board 2 is put on a first pedestal 46, which has a top surface formed as being flat excepting a stair portion 47 corresponding to the lands 19 placed just in back of the corresponding lands 17, in such a way as to be able to effectively support the main board 2, which contains the area of the lands 17, from the back surface thereof. Next, a bonding tool 48 is lowered from a position thereof above the first TCP 5. A pressing portion 49 having a horizontal section substantially rectangular shaped like a character "□", which corresponds to each of the outer leads 16, is formed in the bottom portion of the bonding tool 37. The tips of the outer leads 16 respectively corresponding to the four sides of the TCP are pushed by this pressing portion 49 against the corresponding lands 17 at a time and are simultaneously heated. Further, a solder layer is preliminarily formed on each of the surfaces of the lands 17. The first TCP 5 is soldered to the surface of the main board 2. Moreover, after the connection portions cooling off, the bonding tool 48 is lifted and is thus separated from the outer leads 16.

Subsequently, as illustrated in FIG. 6B, the second TCP 6 is mounted on the main board 2 turned upside down by positioning and adjusting each of the outer leads 18 respectively corresponding to the four sides of the second TCP to the corresponding land 19. This main board 2 is put on a second pedestal 50. The second pedestal 50 has a top surface formed in such a manner as to be flat, excepting a stair portion 51 corresponding to the connection portion of the first TCP 5, which is just in back of the lands 19 formed on the back or bottom surface of the main board 2, to thereby securely support the main board 2 and the connection portion. Next, as illustrated in this figure, a bonding tool 52 is lowered from a position thereof above the second TCP 6. The tips of the outer leads 18 are pushed by a pressing portion 53 formed in the bottom portion of the tool 52, the horizontal section of which is substantially rectangular shaped like a character "□", against the lands 19 at a time and are simultaneously heated. Similarly, solder layers are preliminarily formed on the surfaces of the lands 19. Thus, the second TCP 6 is soldered onto the back surface of the main board 2. In this way, similarly as in the case of the first example, the two TCPs 5 and 6 can be mounted on the top and bottom surfaces of the board in such a manner as to overlap with each other.

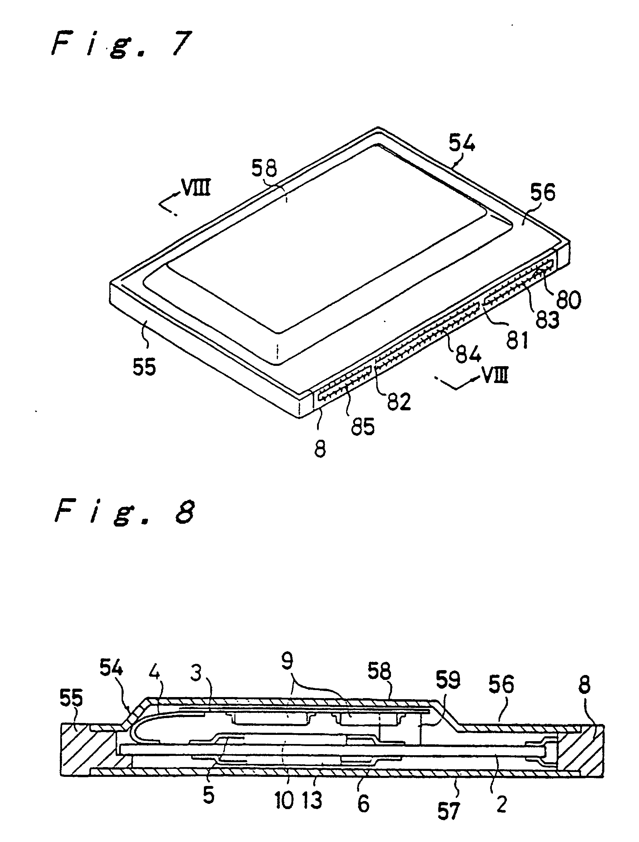

FIG. 7 shows a card-type computer in which the semiconductor device 1 is enclosed in a card-shaped housing 54 similar to what is called an IC card. The housing 54 consists of a frame body 55, which is made of zinc or aluminum die-cast and is shaped nearly like a character "□", a metallic top-surface panel 56 and a flat bottom-surface panel 57, as illustrated in FIGS. 7 and 8. Generally, such a card-shaped housing is a monolithic resin case. However, in the case of the device of the present invention, both of panels 56 and 57 are connected to the frame body 55 by using screws or adhesives. This is because a caulking can not be performed in the device of the present invention due to the facts that there is the fear that the caulking has an ill effect upon the inner circuit board and that moreover, in the case of this example, the frame body 55 is made of a metal practically. In this way, the structure, in which nearly the entire housing 54 is made of an electrically conductive material and the frame body 55, the top-surface panel 56 and the bottom-surface panel 57 are brought into conduction, exerts an electrostatic shielding effect on the main board 2 and the first sub-board 3. Thus the influence of radiation noises of the board and external noises can be cut off. Moreover, noise interference can be effectively precluded. Further, a protruding portion 58 protruding from the periphery thereof by a constant height is formed on the top-surface panel 56.

As is well illustrated in FIG. 8, the semiconductor device 1 is enclosed in the housing 54 in such a manner that the first sub-board 3 faces the main board 2 by bending the FPC 4. The main board 2 is fixed to the frame body 55 with, for example, screws or the like. The main board 2 and the first sub-board 3 are spaced apart at a constant interval by a spacer member 59 inserted therebetween and are connected as a unit in such a fashion as to face each other. Further, a block made of an insulating material having some flexibility, for instance, a polycarbonate resin is used as the spacer member 59 which can be fixedly glued to the surfaces of both of the boards facing each other, preferably to portions in the vicinity of the center of each of these faces, with an adhesive or the like. Thus the thickness of the entire semiconductor device 1 can be further reduced by performing such a fixing method. Moreover, excessive stress does not act upon each of the circuit boards 2 and 3 owing to the flexibility of the spacer member 59. Thus the boards are insensitive to vibration and shock. Further, nearly the entire first sub-board 3 is enclosed in the protruding portion 58 of the top-surface panel 56.

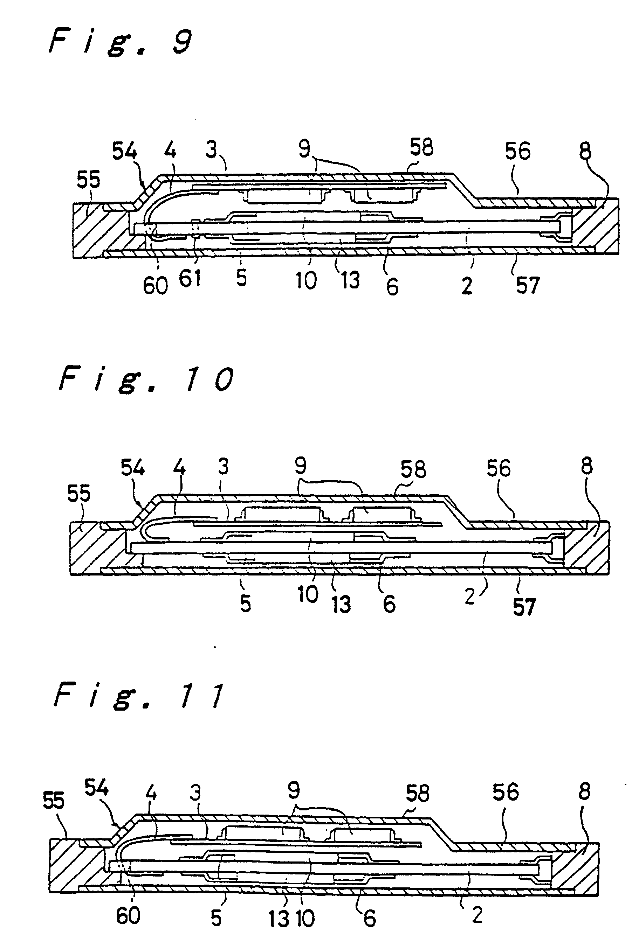

In the case of this example, the surface of the main board 2, on which the first TCP 5, namely, the CPU 10 is mounted, faces the first sub-board 3. Moreover, the surface of the first sub-board 3, on which the RAM 9 is mounted, faces the main board 2. Furthermore, as the result of connecting the FPC 4 to the surface, on which the CPU 10 is mounted, of the main board 2, as described above, there is little necessity of boring through holes in the main board 2. Further, the CPU 5 can be connected with the sub-board 3. Consequently, the area of the main board can be further reduced. Thereby, the miniaturization of the board can be achieved. Moreover, the degrees of freedom in circuit design and wiring can be increased. Another example of FIG. 9 is different from the example of FIG. 8 in that the FPC 4 is connected to a surface of the main board 2 opposite to the surface thereof facing the first sub-board 3. Thus, a notch portion 60. through which the FPC 4 is drawn, is formed in a side edge portion of the main board 2. Furthermore, because the CPU 10 is mounted on the surface of the main board 2 opposite to the surface thereof to which the FPC 4 is connected, a through hole 61 for connecting the CPU 10 with the FPC 4 is bored in the main board 2. However, with such a configuration, the FPC 4 can be bent at a curvature larger than that in the case of the example of FIG. 3. Consequently, a load imposed on the connection portion between the FPC 4 and the main board 2 can be further reduced. Moreover, an occurrence of a disconnection or a breakage in the connection portion can be prevented.

Further, in the case of still another example, the first TCP 5 and the second TCP 6 can be replaced with each other in the configuration of FIG. 8. In this case, the CPU is mounted on the surface of the main board 2 opposite to the surface thereof, to which the FPC 4 is connected. Thus it is necessary to bore a through hole in the main board 2 similarly as in the case of the example of FIGS. 4A and 4B. However, the CPU 10, which can generate heat more than the I/O sub-system chip 13 does, is placed at the side of and in the vicinity of the bottom-surface panel 57. Therefore, a rise in internal temperature can be restrained by the heat dissipating action of the bottom-surface panel.

In the case of yet another example, the first TCP 5 and the second TCP 6 can be replaced with each other in the configuration of FIG. 9. In this case, the CPU is mounted on the same surface of the main board 2, to which the FPC 4 is connected. Thus there is no necessity of boring a through hole in the board 2. The curvature of the FPC 4 becomes large, so that a load imposed on the connection portion between the FPC 4 and the main board 2 can be small. Moreover, the CPU 5 is placed on the surface of the board 2 facing the bottom-surface panel 57. Thereby, this example has an advantage in that a higher heat dissipating effect can be obtained.

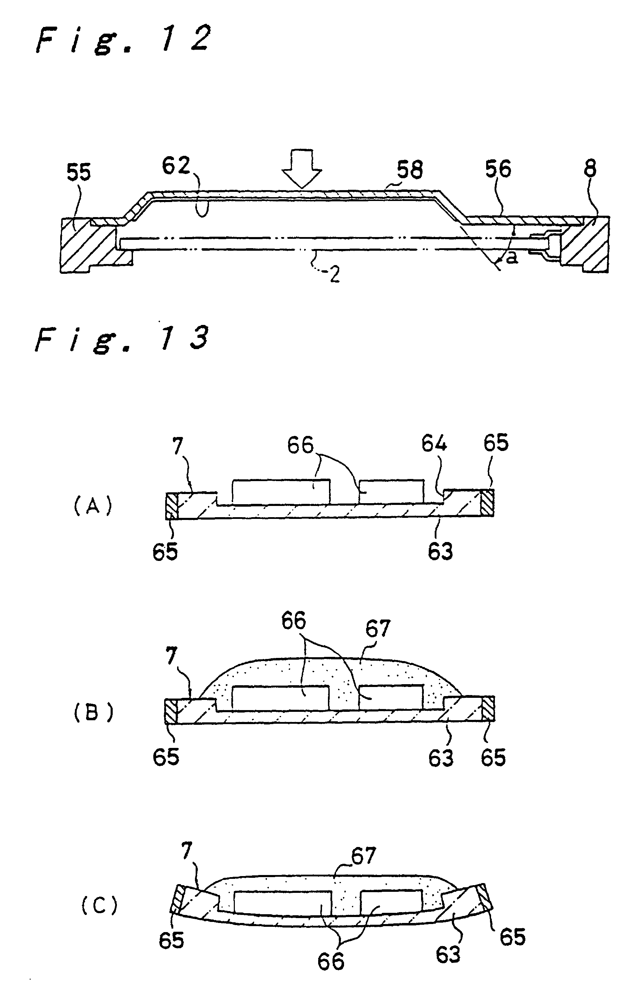

FIGS. 10 and 11 illustrate examples of the modifications of the configurations of FIGS. 8 and 9, respectively. Namely, in the cases of the examples of FIGS. 10 and 11, the surface of the first sub-board 3 opposite to the surface thereof, on which the RAM 9 is mounted, faces the main board 2. Therefore, the thickness of the entire device becomes a little larger in comparison with those in the cases of the examples of FIGS. 3, 4A and 48. However, the RAM 9 is placed on the surface of the board 2 facing the top-surface panel 56 and in the vicinity thereof. Thus a rise in internal temperature due to the RAM 9 can be restrained by the heat dissipating action of the top-surface panel. Further, the connecting position of the FPC 4, the placement of the CPU 10 and effects obtained due to the positional relation therebetween are the same as in the cases of FIGS. 8 and 9. Thus the description thereof is omitted here.

The top-surface panel 56 of the casing 54 is constituted by a metal plate, in which an outwardly protruding portion 58 is formed by drawing. Further, from viewpoints of limiting the thickness of the entire casing 54 to a predetermined value and of preventing an occurrence of deformation due to external force in use as illustrated in FIG. 12, it is convenient that a firm material such as a stainless steel, which has a Vickers hardness ranging from 150 to 250 and a thickness of 0.2 mm, is used as this metal plate. Especially, in the case where such a card-like housing 54 is handled by hand, the external force acts upon the nearly central portion of the top-surface panel. However, even when the top-surface panel 56 is dented somewhat, such deformation has little effect upon the board because of the fact that the aforementioned spacer member 59 is placed in the nearly central portion of the board.

It is preferable to set the climbing or rising angle of the protruding portion 58 as 45 to 90 degrees, because the portion 58 can achieve so high rigidity to withstand pressure exerted by a finger thereon and can have a space sufficient to enclose the first sub-board 3 even if the size of the sub-board 3 becomes large due to increased in memory capacity. As illustrated in these figures, the top-surface panel 56 is formed as being flat excepting the rising part of the protruding portion 58. Thus, during assembling, the positioning of the protruding portion 58 onto the frame body 55 can be easily achieved. Consequently, the productivity can be improved and an assemblage can be facilitated. Further, in the case of this example, the strength of the connector 8 at the time of attaching or detaching the card-type computer can be increased by spacing the protruding portion 58 and the connector 8 out by a certain distance. Moreover, a known resist material 62 is applied onto nearly the entire inner surface of the protruding portion 58 of the top-surface panel 56, which includes the rising portion thereof, for the purpose of preventing the inner surface of the protruding portion 58 from making direct contact with the first-sub board 3. Here, note that the resist material is not applied onto the inner surface of portions of the top-surface panel 56 other than the protruding portion 58. Thus, there is no fear that deformation and peeling occur owing to high temperature. Further, the resist material 62 may be applied only to the flat part of the inner surface of the protruding portion 58 other than the rising part thereof.

FIGS. 13A to 13C illustrate sections of the structure of the second-board 7 and a process for manufacturing the second-board 7. In the case of this example, the second-board 7 is constituted by a four-layer wiring board 63 which has a thickness of 1 mm or so. The thickness of the central region 64 of this board for mounting electronic components thereon is preliminarily reduced almost by half so as to realize a thin board. A thinner wiring board having a thickness of 0.3 mm or so may be used as the board 63. A large number of terminals 65 to be connected to the pads of the main board 2 by soldering are provided on the peripheral edge of the wiring board 63.

First, as illustrated in FIG. 13A, a plurality of electronic components 66 such as a logic IC and a microcomputer are placed at predetermined positions in the central region 64 and are connected thereto by performing a known method such as a wire bonding or soldering. Next, as illustrated in FIG. 13B, a thermosetting protective resin 67 is applied thereto in such a manner as to cover the electronic components 66 and the entire central region 64. Then, the protective resin 67 is set by the application of heat thereon. Thereafter, when cooling the protective resin 67, upward warpage occurs in the peripheral region of the board 63, as illustrated in FIG. 13C, owing to the difference in coefficient of thermal expansion between the central region 64 and the peripheral region of the board 63, which is caused by lack of rigidity of the thin central portion 64.

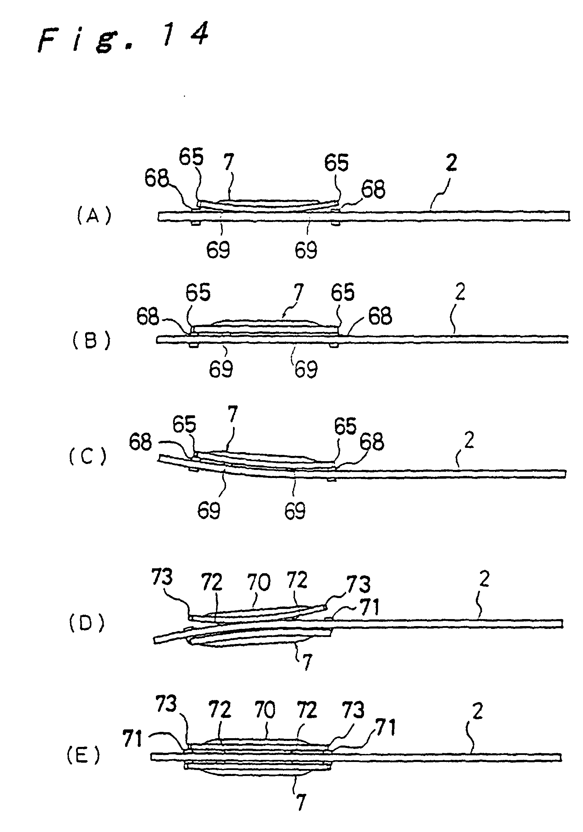

Even if the second sub-board 7 having the peripheral portion upwardly warped is once placed precisely at a predetermined position on the main board 2, slight movement of the main board 2 easily causes the sub-board 7 to move from the predetermined position. Thus it is very difficult to accurately and securely connect the second sub-board 7 with the main board 2. Moreover, in the case where the sub-board 7 is connected to the main board 2 at the predetermined position but the main board 2 is similarly thin and does not have sufficient rigidity, the main board 2 may deform in conformity with the warpage occurring in the second sub-board 7. FIGS. 14A to 14E illustrate a method, by which the warped sub-board is mounted at predetermined position on the main board without producing deformation in the main board, step by step.

A large number of corresponding pads 68 to be connected with terminals 65 of the second sub-board 7 are preliminarily formed on the surface of the main board 2. As illustrated in FIG. 14A, the bottom surface of the second sub-board 7 is tentatively glued onto the main board 2 with an adhesive 69 while the positioning thereof is performed. Although it is preferable that the adhesive 69 is applied to at least two places or more than two places on the bottom surface of the sub-board 7, the adhesive 69 may be applied only to a single place thereon unless the sub-board 7 is shifted from the predetermined position. Therefore, if it is found after the tentative gluing that the second sub-board 7 is not precisely placed at the predetermined position, the sub-board 7 can be easily removed therefrom and then the positioning of the sub-board 7 can be carried out again. Moreover, if the sub-board 7 is once placed at the predetermined position precisely, the sub-board 7 can not be easily moved by shifting the main board 2. Next, each of the terminals 65 of the second sub-board 7 is connected to the corresponding one of the pads 68 of the main board 2 by performing a well known reflow soldering method, by which each of the terminals is heated at about 230 degrees centigrade in the period of about 10 seconds by utilizing infrared radiation or hot air. As illustrated in FIG. 14B, the warpage occurred in the second sub-board 7 disappears due to the thermal expansion of the protective resin 67 during heating. Thus the sub-board 2 is put back into a flat state. However, when the board is cooled down to an ordinary temperature, warpage is caused also in the main board 2 by the warping force of the second sub-board 2, as illustrated in FIG. 14C.

Subsequently, the main board 2 is turned upside down as illustrated in FIG. 14D. Then, a third sub-board 70 is put on the back surface of the main board 2. Further, the third sub-board 70 is equipped with analog circuit parts such as a floppy disk drive, an A/D converter and a PLL. The third sub-board 7 has nearly the same size and shape as the second sub-board 2 does. Moreover, upward warpage is caused owing to the difference in coefficient of thermal expansion between the thermosetting protective resin of the central portion and the peripheral portion. Conversely, as the result of being turned upside down, the main board 2 warps downwardly. A large number of pads 71 are preliminarily formed on the back surface of the main board 2 so as to mount the third sub-board 7 and the second sub-board 70 on both side surfaces of the main board in such a manner that the mounting positions of the sub-boards 7 and 70 are symmetrical with respect to the main board. The third sub-board 70 positioned at the predetermined position is tentatively glued to a place on the back surface of the main board 2 with an adhesive 72 at a location of the bottom surface thereof unless the sub-board 70 is displaced from the predetermined position. If it turns out in this state that the third sub-board 70 is not precisely positioned at the predetermined position, the sub-board 70 is removed from the back surface of the main bard 2 and the positioning thereof can be performed again. Further, the sub-board 70 is heated by a well known means. Then, the terminal 73 provided on the peripheral edge portion of the third sub-board is connected to the corresponding pad 71 by performing a reflow soldering, as illustrated in FIG. 14E. As described above, during heating, the warpage disappears in the second sub-board 7 and the third sub-board 70 and thus these sub-boards become flat. Therefore, as long as the positioning of the third sub-board 70 is precisely performed, the soldering can be easily achieved. The warping forces of the sub-boards 7 and 70 is balanced by connecting the sub-boards 7 and 70 with each other in such a manner that the positions of the sub-boards 7 and 70 are symmetric with respect to the main board 2. Further, the warping forces of the sub-boards 7 and 70 act in opposite directions, so that the main board 2 is held in a straight and flat state as illustrated in FIG. 14E even after cooled down to an ordinary temperature. Furthermore, even in the case where both of the sub-boards are different in size from each other, an occurrence of warpage in the main board 2 can be restrained by mounting both of the sub-boards in such a manner that the positions of these sub-boards are nearly symmetric with respect to the main board 2.

Among the large number of the terminals 73, only one of the terminals is provided as a unified power supply terminal of the third sub-board 70, which is connected to a power supply line of the main board 2. When a circuit board is miniaturized similarly as in the case of the printed circuit board of the present invention, an operation of a digital circuit part is stabilized, whereas an analog circuit part becomes susceptible to the influence of noises. Especially, a memory board such as the first sub-board 3 of this embodiment is likely to generate noise and to cause variation in power supply voltage. Such a memory board has a great influence on the analog circuit part. In accordance with the present invention, the analog circuit part is formed on a circuit board other than the main board 2 and a unified power supply is provided. Thereby, the influence of variation in power supply potential of the digital circuit part can be reduced. Consequently, an operation of the device of the present invention can be stabilized. Further, a space for the third sub-board 70 and the main board 2 can be saved by unifying power supplies. Moreover, the size of the entire semiconductor device can be reduced. Furthermore, the cost thereof can be decreased. Additionally, noises can be cut off more securely by adding a filter to a power supply circuit of the third sub-board 70, if necessary.

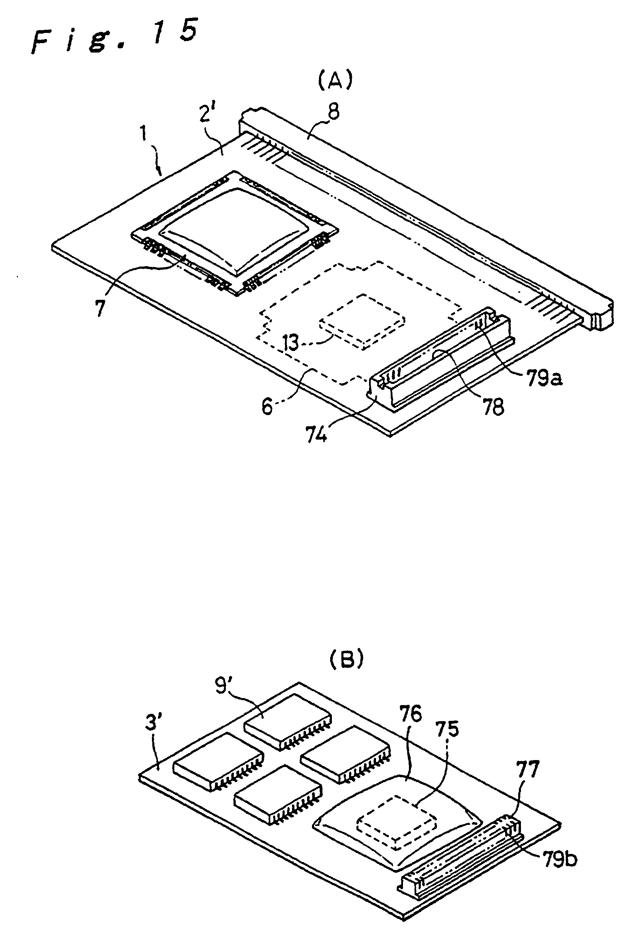

FIGS. 15A and 15B illustrate another semiconductor device embodying the present invention, namely, a second embodiment of the present invention. This semiconductor device consists of a main board 2' of FIG. 15A and a first sub-board 3' of FIG. 15B, which are electrically and mechanically detachably connected to each other by means of a pair of connectors instead of the FPC 4 of the first embodiment of FIG. 1. The main board 2' has the same configuration as the main board 2 of the first embodiment except that the main board 2' is not equipped with means equivalent to the first TCP 5 of the first embodiment, namely, a CPU and that an elongated female connector 74 is mounted on the top surface of the main board 2'. In the case of the second embodiment, a CPU 75 constituted by a bare chip is directly connected to the first sub-board 3' by performing what is called a Chip on Board (COB) method and further is coated with a protective resin 76.

Further, in the first sub-board 3', four RAMs 9' composing a main memory of the semiconductor device are mounted on the same surface, on which the CPU 75 is mounted, as illustrated in RG. 15B. Moreover, an elongated male connector 77 corresponding to the female connector 74 of the main board 2' is mounted on the first sub-board 3'. Furthermore, the CPU 75 and the RAM 9' are interconnected through a data bus provided on the first sub-board 3'. As a result, the wiring length between the CPU 75 and the RAM 9' can be reduced in comparison with the corresponding wire length in the case of the first embodiment. Especially, in the case of this embodiment, a microprocessor "80486" (Clock Frequency: 33 MHz) manufactured by the Intel Corporation of the U. S. A. is employed as a CPU. Thus, it is convenient that a processing can be performed at a higher speed by sufficiently offering the performance of the microprocessor.

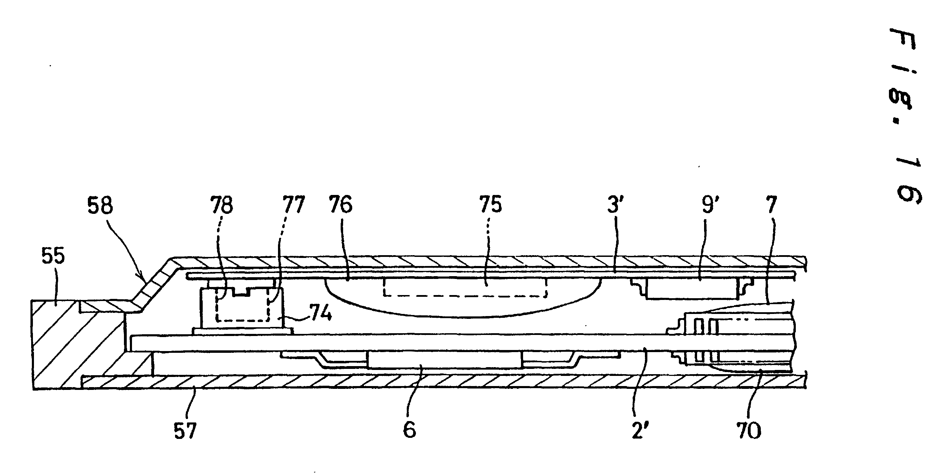

The female connector 74 is placed on the top surface of the main board 2' along the short side thereof opposite to the other short side along which the second sub-board 7 is mounted thereon. Moreover, an elongated slot-like connection portion 78 for complementing the male connector 77 is provided on the top surface of the board 2 along the long side thereof in such a manner to open upwardly. In the connection portion 78, two rows of, for example, 100-pin connection terminals 79a are provided at a narrow pitch of 0.5 mm along the left and right long sides. In contrast, the male connector 77 is placed in the proximity of the CPU 75 along one of the side edges of the first sub-board 3'. Further, two rows of 100-pin connection terminals 79b respectively corresponding to the two rows of the connection terminals 79a of the connection portion are provided at a narrow pitch of 0.5 mm along the left and right long sides on the outer surface of the male connector 77. Generally, in the case of a connector of such a type, the pitch of terminals for a wiring can be narrower in comparison with the FPC. Even when the number of signal lines is increased to 32 (corresponding to 32 bits) or more, a connector of such a type can flexibly meet the increase in number of signal lines by requiring a smaller space, in comparison with the case of employing the FPC. As is well illustrated in FIG. 16, the main board 2' and the first sub-board 3' are integrally extractably coupled or connected to each other by facing the surface, on which the CPU is mounted, of the first sub-board 3' downwardly to the main board 2' and next forcibly fitting the male connector 77 into the connection portion 78 of the female connector. At that time, the CPU 75 coated with the protective resin 76 is enclosed in a space among the connectors 74 and 77 and the second sub-board 7, which corresponds to a space, where the first TCP 5 is provided, in the case of the first embodiment. The thickness of the entire semiconductor device can be reduced. Further, it is convenient for securing electric connection between the main board 2' and the first sub-board 3' that the board 2' is fixed to the sub-board 3' by keeping a constant interval therebetween by use of an appropriate spacer member (not shown), similarly as in the case of the first embodiment. Naturally, both of the main board 2' and the first sub-board 3' can be mechanically fixed without the spacer member by using only connectors. Incidentally, various connectors of various types other than the aforementioned type may be used as the connectors 74 and 77. Additionally, each of the connectors 74 and 77 may be placed at various positions other than the aforementioned positions employed in the case of the embodiments, for instant, on the central portion of the main board.

Thus, in accordance with the present invention, there can be provided a semiconductor device which has the adaptability to a special purpose, namely, ability to easily adapt to diverse functional requirements and operating conditions by suitably selecting a CPU to be mounted on the first sub-board and also selecting the memory capacity of a main memory. Thereby, the configuration of the main board can be formed in such a manner as to be able to be used in common for various purposes by unifying primary modules to be provided thereon. This is advantageous to the manufacturing of semiconductor devices. Especially, the second embodiment is different in pin configuration or assignment of the CPU from the first embodiment. Moreover, in the case of the second embodiment, the number of interconnecting lines or wires to be connected to the CPU is increased, in comparison with the case of the first embodiment. The semiconductor device of the present invention can easily adapt to such a change of the CPU. Moreover, in accordance with the present invention, the wiring space of the main board can be increased. In addition, there is no limit to the wiring on the main board due to the CPU. Thus the present invention has an advantage in that the degrees of freedom in wiring design is increased.

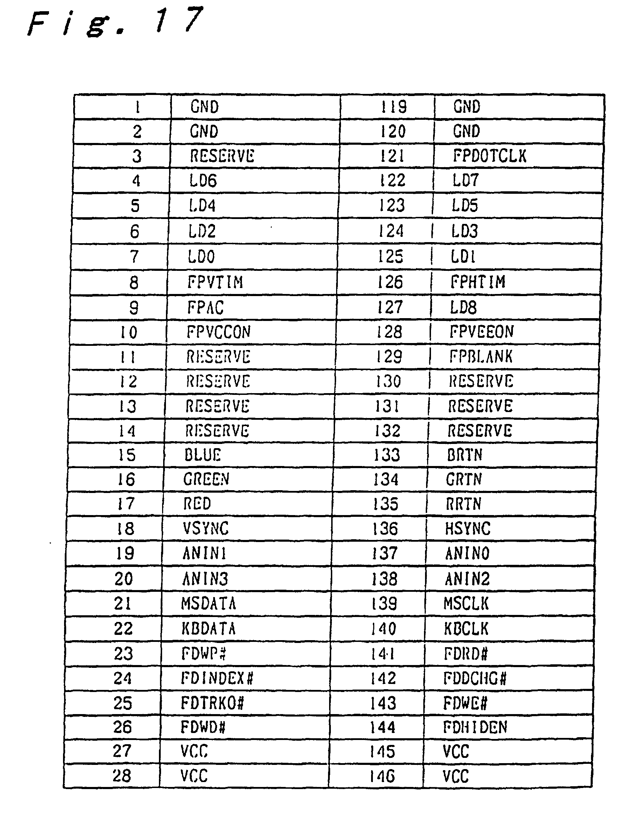

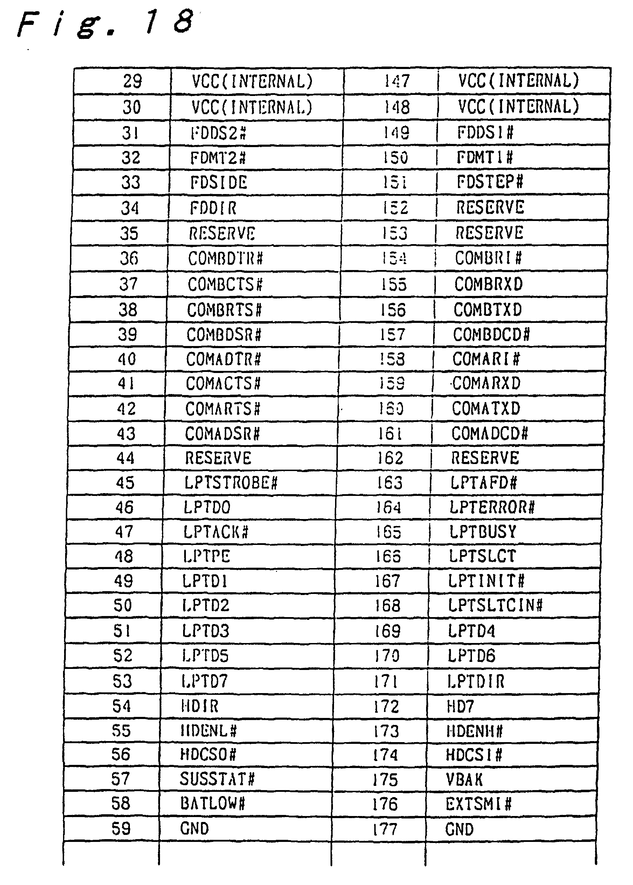

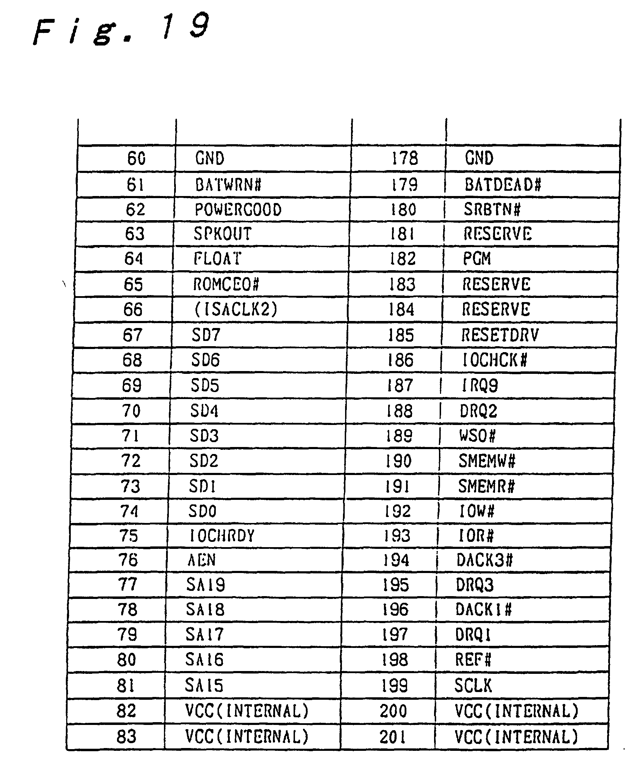

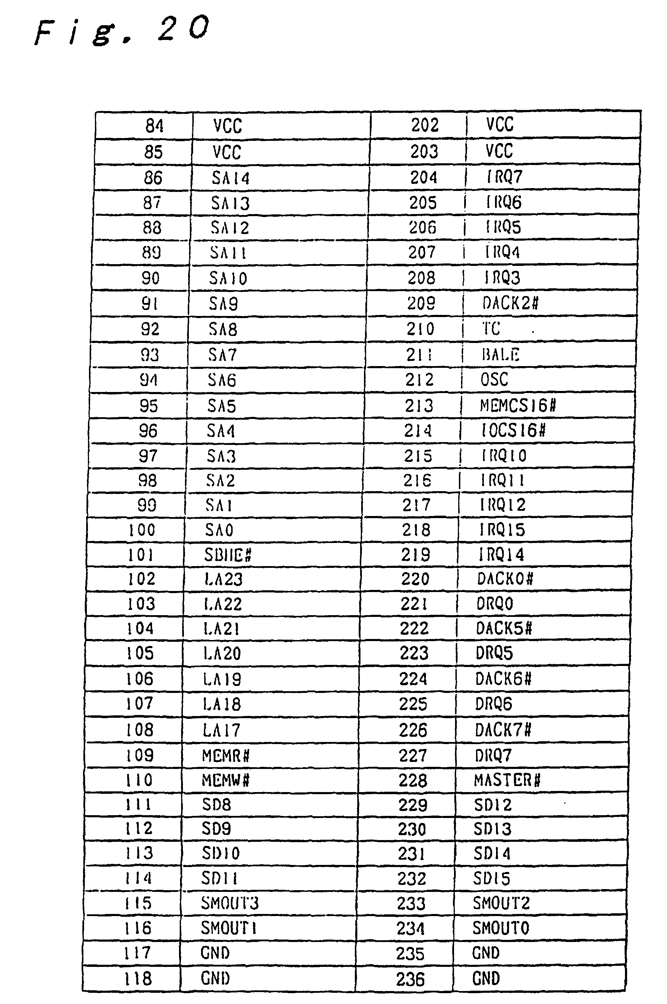

FIGS. 17 to 20 illustrate the terminal configuration or assignment of the connector 8 of the semiconductor device 1, namely, of the aforesaid card-type computer. As shown in FIG. 7, the connector 8 has a configuration comprising upper and lower lines of 118 pins. In this way, with the improvement of the performance of the semiconductor device, the number of pins of the connector 8 has been increased. Moreover, with the reduction in size of the semiconductor device, the pitch of pins of the connector 8 has been narrowed. Thus, an opening 80 of the connector 8 is divided or partitioned by two reinforcing ribs 81 and 82, which are provided at horizontally asymmetric positions along the longitudinal direction of the connector, into three opening portions 83 to 85, which are different in length from one another. Corresponding to this, the aforementioned terminal configuration is divided into three regions, namely, a first region of FIG. 17, a second region of FIGS. 18 and 19 and a third region of FIG. 20. The ribs 81 and 82, which are placed at the horizontally asymmetric positions, uniquely determine the direction in which the connector 8 is connected to an equipment. Thus, in the case where the card type computer is used by being connected to an equipment, there is no fear that the card type computer is fitted to the equipment in an erroneous direction. Moreover, naturally, in the case where the connector 8 is not of the female type as in the case of this embodiment but is of the male type, slot portions are provided therein in place of the ribs to thereby divide the terminal configuration.

In the first region of FIG. 17, there are two parallel upper and lower rows of 28 pins, the pin numbers of which are 1 to 28 and 119 to 146. This region contains pins for connecting the computer primarily to external peripheral devices such as a liquid crystal display (LCD), a cathode ray tube (CRT), a keyboard, a mouse and a floppy disk drive unit. Further, in the second region of FIGS. 18 and 19, there are two rows of 55 pins whose pin numbers are 29 to 83 and 147 to 201. The second region contains pins associated with a serial interface, a power management system and an AT bus (or expansion bus). Moreover, in the third region of FIG. 20, there are two rows of 35 pins whose pin numbers are 84 to 118 and 202 to 236. This region contains pins concerning, for example, a serial interface, a parallel interface, a hard disk drive unit and a power management system. Furthermore, the output voltage level of signals assigned to these pins are 3.3 or 5 V. In the case where the signals have such relatively low output voltage levels, it is important to stabilize the signal output by eliminating the influence of external noises and radiation noises caused in the circuit.

As illustrated in FIG. 17, a flat panel data shift clock signal (FPDOTCLK) for an LCD interface is assigned to a pin No. 121 adjacent to a pin No. 120, to which a grounding line signal (GND) is assigned. This FPDOTCLK signal is one of control signals used for displaying an image in a flat panel display and more particularly, is a clock signal for shifting display data. The electric potential of this signal is stabilized by assigning this signal to a pin adjoining to another pin to which a grounding line signal. Thereby, a displaying operation of the LCD can be stabilized.

Further, a blue signal (BLUE), a green signal (GREEN) and a red signal (RED) of an RGB signal for a CRT are assigned to pins Nos. 15 to 17 of FIG. 17, respectively, as signals for a CRT interface. Moreover, return signals (BRTN, GRTN, PRTN) corresponding to the blue, green and red signals assigned to the pins Nos. 15 to 17 of one of the two rows are assigned to pins Nos. 133 to 135 of the other row, respectively, which are placed at the positions respectively facing the pins Nos. 15 to 17. The external noises and so forth are canceled by putting the circumstances of pins for outputting analog color signals for a CRT (namely, the red, green and blue signals) as close as possible to those of pins for receiving the corresponding return signals. Thus, a display on the CRT becomes insensitive to the influence of the noises. Consequently, the quality of a display on the CRT can be improved. Further, the high quality of a display on the CRT can be maintained.

Although the preferred embodiments of the present invention have been described above, it should be understood that the present invention is not limited thereto and that other modifications will be apparent to those skilled in the art without departing from the spirit of the invention. For example, the main board and the first sub-board of the first embodiment can be connected with each other through the connector of the second embodiment. Conversely, the main board and the first sub-board of the second embodiment can be connected with each other through the FPC of the first embodiment. Further, various known methods other than soldering, for example, a method of alloying the lead with land through a thermocompression, a method of using a sheet-like anisotropic electrically conductive film and a method of using a photo-curing insulating resin may be employed as a method for connecting the TCP with the circuit board. Moreover, the present invention can be also applied to cases of mounting other package type electronic components having leads, for instance, a QFP, on the board, similarly to the TCP.

## Claims

1. A plug-in card type semiconductor device having a CPU (10), an input/output device (13) and a memory (9), which are mounted on circuit boards (2, 3), wherein the circuit boards include:
a main circuit board (2); and
a sub-circuit-board (3) electrically connected to the main circuit board through a flexible printed circuit (4), wherein
the memory (9) comprises a memory element mounted on the sub-circuit-board (3).

2. The device according to claim 1, wherein the CPU (10) is mounted on the main circuit board (2).

3. The device according to claim 1, wherein the CPU (10) is mounted on the sub-circuit-board (3).

4. The device according to claim 1, wherein the sub-circuit-board (3) is placed in such a manner as to face the main circuit board (2) by bending the flexible printed circuit (4), wherein the flexible printed circuit is connected to a surface of the main circuit board, which is opposite to another surface thereof facing the sub-circuit-board.

5. The device according to claim 4, which further comprises means for integrally fixing the main circuit board and the sub-circuit-board so as to face each other.

6. The device according to any one of claims 1 to 5, which further comprises a card-shaped thin housing (54) for enclosing the main circuit board (2) and the sub-circuit-board (3) therein, wherein at least a surface of the housing is made of a metal plate (56) outwardly protruded by drawing.

7. The device according to claim 1, which further comprises a connector (8) in which a large number of terminals to be connected to an external apparatus are arranged, wherein two of the terminals are a dot clock signal terminal to be connected to an external liquid crystal display and a grounding terminal adjacent to the dot clock signal terminal.

8. The device according to claim 1, which further comprises a connector (8) in which a plurality of rows of a large number of terminals to be connected to an external apparatus are arranged, wherein three of the terminals of one of the plurality rows are an R-signal terminal, a G-signal terminal and a B-signal terminal which are connected to an external CRT, wherein three of the terminals of another of the plurality rows, which is parallel to the one of the plurality rows, are an R-return-signal terminal, a G-return-signal terminal and a B-return-signal terminal which correspond to the R-signal terminal, the G-signal terminal and the B-terminal, respectively, and are placed at positions facing the R-signal terminal, the G-signal terminal and the B-signal terminal, respectively.

9. The device according to claim 1, which further comprises a connector (8) in which a large number of terminals to be connected to an external apparatus are arranged, wherein the connector has means for dividing a row of the terminals into horizontally asymmetric portions arranged along the row.

10. The device according to claim 1, which further comprises a second sub-circuit-board (7) mounted on a surface of the main circuit board (2), wherein an analog circuit part is mounted on the second sub-circuit-board, wherein a power supply terminal of the second sub-circuit-board is connected to a place of the main circuit board.

11. The device according to claim 1 in which a first IC package (5) and a second IC package (6) are mounted on a first surface and a second surface of said main circuit board (2), respectively, and which further comprises:
a first connection portion (A) for connecting leads (16) of the first IC package with first terminal areas (17) formed on the first surface; and
a second connection portion (A) for connecting leads of the second IC package with second terminal areas (19) formed on the second surface, wherein the first surface is opposite to the second surface, wherein the first IC package (5) and the second IC package (6) are placed in such a manner that the second connection portion provided on the second surface is just in back of the first connection portion provided on the first surface.

12. The device according to claim 11, wherein the second connection portion provided corresponding to one side of the second IC package (6) is just in back of the first connection portion provided corresponding to a corresponding side of the first IC package (5).

13. The device according to claim 11, wherein the second connection portion provided corresponding to each of all of four sides of the second IC package (6) is just in back of the first connection portion provided corresponding to a corresponding one of all of four sides of the first IC package (5).

14. The device according to claim 11, 12 or 13, wherein the first and second IC packages (5, 6) are equipped with IC chips (10, 13) which operate in conjunction with one another.

15. The device according to claim 14, wherein the first IC package (5) is equipped with said CPU (10), and the second IC package (6) is equipped with said I/O device (13) which operates in response to the CPU.

16. The device according to claim 11, 12, 13, 14 or 15, wherein the first IC package (5) and/or the second IC package (6) is a tape carrier package.

17. The device according to claim 1, further comprising:
a first IC package (5); and
a second IC package (6), wherein the first IC package and the second IC package are mounted on both of opposite surfaces of said main circuit board (2) in such a manner that the second IC package (6) is just in back of the first IC package (5), wherein the first IC package and the second IC package are connected to the opposite surfaces of the printed circuit board, respectively, through a die bonding, wherein the first IC package and the second IC package are thermally connected to each other through a via hole (33) bored through the main circuit board (2) in such a manner that heat is able to be transferred between the first IC package and the second IC package.

18. The device according to claim 17, wherein leads (16, 18) of the first IC package (5) and the second IC package (6) respectively mounted on the opposite sides of the main circuit board are coated with a thermally conductive resin (34).

## Patentansprüche

1. Eine Halbleitervorrichtung in Steckkartenform, welche eine CPU (10), eine Eingangs-/Ausgangsvorrichtung (13) und einen Speicher (9) aufweist, welche auf Leiterplatten (2, 3) montiert sind, wobei die Leiterplatten aufweisen:
eine Hauptleiterplatte (2); und
eine Nebenleiterplatte (3), welche durch eine flexible gedruckte Schaltung (4) mit der Hauptleiterplatte elektrisch verbunden ist,
wobei der Speicher (9) ein Speicherelement aufweist, welches auf der Nebenleiterplatte (3) montiert ist.

2. Vorrichtung nach Anspruch 1, wobei die CPU (10) auf der Hauptleiterptatte (2) montiert ist.

3. Vorrichtung nach Anspruch 1, wobei die CPU (10) auf der Nebenleiterplatte (3) montiert ist.

4. Vorrichtung nach Anspruch 1, wobei die Nebenleiterplatte (3) in einer Weise angeordnet ist, dass sie der Hauptleiterplatte (2) durch Biegen der flexiblen gedruckten Schaltung (4) gegenüberliegt, wobei die flexible gedruckte Schaltung mit einer Oberfläche der Hauptleiterplatte verbunden ist, welche einer weiteren der Nebenleiterplatte zugewandten Oberfläche entgegengesetzt ist.

5. Vorrichtung nach Anspruch 4, welche des weiteren Mittel zur einstückigen Befestigung der Hauptleiterplatte und der Nebenleiterplatte aufweist, damit diese sich gegenüber liegen.

6. Vorrichtung nach einem der Ansprüche 1 bis 5, welche des weiteren ein kartenförmiges dünnes Gehäuse (54) aufweist, welches die Hauptleiterplatte (2) und die Nebenleiterplatte (3) umschließt, wobei zumindest eine Oberfläche des Gehäuses aus einer Metallplatte (56) gefertigt ist, die durch Tiefziehen nach außen hervorstehend geformt ist.

7. Vorrichtung nach Anspruch 1, welche des weiteren einen Stecker (8) aufweist, in welchem eine große Anzahl von mit einem externen Apparat zu verbindenden Anschlüssen angeordnet sind, wobei es sich bei zwei der Anschlüsse um einen Anschluss für ein Punkt-Taktsignal, der an eine externe Flüssigkristallanzeige anzuschließen ist, und um einen Masseanschluss handelt, der zu dem Anschluss für das Punkt-Taktsignal benachbart ist.

8. Vorrichtung nach Anspruch 1, welche des weiteren einen Stecker (8) aufweist, in welchem eine Vielzahl von Reihen mit einer großen Anzahl von Anschlüssen, die mit einem externen Apparat zu verbinden sind, angeordnet sind, wobei es sich bei drei der Anschlüsse einer der Vielzahl von Reihen um einen R-Signal-Anschluss, einen G-Signal-Anschluss und einen B-Signal-Anschluss handelt, die mit einer externen Kathodenstrahlröhre verbunden sind, und wobei es sich bei drei der Anschlüsse einer anderen der Vielzahl von Reihen, welche zu der einen der Vielzahl von Reihen parallel ist, um einen R-Rückkehrsignal-Anschluss, einen G-Rückkehrsignal-Anschluss und einen B-Rückkehrsignal-Anschluss handelt, welche den R-Signal-, G-Signal- und B-Signal-Anschlüssen entsprechen und welche an Positionen angeordnet sind, die den R-Signal, G-Signal- und B-Signal-Anschlüssen gegenüberliegen.

9. Vorrichtung nach Anspruch 1, welche des weiteren einen Stecker (8) aufweist, in welchem eine große Anzahl von mit einem externen Apparat zu verbindenden Anschlüssen angeordnet sind, wobei der Stecker Mittel zum Unterteilen einer Reihe von Anschlüssen in horizontal asymmetrische Teile besitzt, die entlang der Reihe angeordnet sind.

10. Vorrichtung nach Anspruch 1, welche des weiteren eine zweite Nebenleiterplatte (7) aufweist, welche auf einer Oberfläche der Hauptleiterplatte (2) montiert ist, wobei ein analoger Schaltungsteil auf der zweiten Nebenleiterplatte montiert ist und wobei ein Energieversorgungsanschluss der zweiten Nebenleiterplatte mit einer Stelle der Hauptleiterplatte verbunden ist.

11. Vorrichtung nach Anspruch 1, bei welcher ein erstes IC-Gehäuse (5) und ein zweites IC-Gehäuse (6) auf einer ersten Oberfläche bzw. einer zweiten Oberfläche der Hauptleiterplatte (2) montiert sind, und welche des weiteren aufweist:
einen ersten Verbindungsabschnitt (A) zum Verbinden von Leitungen (16) des ersten IC-Gehäuses mit ersten Anschlussflächen (17), die auf der ersten Oberfläche ausgebildet sind; und
einen zweiten Verbindungsabschnitt (A) zum Verbinden von Leitungen des zweiten IC-Gehäuses mit zweiten Anschlussflächen (19), die auf der zweiten Oberfläche ausgebildet sind,
wobei die erste Oberfläche der zweiten Obernäche entgegengesetzt ist, und wobei das erste IC-Gehäuse (5) und das zweite IC-Gehäuse (6) in einer Weise angeordnet sind, dass der zweite sich auf der zweiten Oberfläche befindende Verbindungsabschnitt im Rücken des ersten sich auf der ersten Oberfläche befindenden Verbindungsabschnitts liegt.

12. Vorrichtung nach Anspruch 11, wobei sich der zweite Verbindungsabschnitt, der entsprechend einer Seite des zweiten IC-Gehäuses (6) vorgesehen ist, direkt im Rücken des ersten Verbindungsabschnitts, der entsprechend einer entsprechenden der vier Seiten des ersten IC-Gehäuses (5) vorgesehen ist, liegt.

13. Vorrichtung nach Anspruch 11, wobei der zweite Verbindungsabschnitt, der entsprechend jeder der vier Seiten des zweiten IC-Gehäuses (6) vorgesehen ist, direkt im Rücken des ersten Verbindungsabschnitts, der entsprechend einer entsprechenden Seite aller vier Seiten des ersten IC-Gehäuses (5) vorgesehen ist, liegt.

14. Vorrichtung nach Anspruch 11, 12 oder 13, wobei das erste und das zweite IC-Gehäuse (5, 6) mit IC-Chips (10, 13) ausgestattet sind, die in Verbindung miteinander arbeiten.

15. Vorrichtung nach Anspruch 14, wobei das erste IC-Gehäuse (5) mit der CPU (10) und das zweite IC-Gehäuse (6) mit der Eingangs-/Ausgangsvorrichtung (13) ausgestattet ist, welche in Antwort auf die CPU arbeitet.

16. Vorrichtung nach Anspruch 11, 12, 13, 14 oder 15, wobei es sich bei dem ersten IC-Gehäuse (5) undloder dem zweiten IC-Gehäuse (6) um ein von einem Streifen getragenes Gehäuse handelt.

17. Vorrichtung nach Anspruch 1, weiterhin aufweisend:
ein erstes IC-Gehäuse (5), und
ein zweites IC-Gehäuse (6),
wobei das erste IC-Gehäuse und das zweite IC-Gehäuse auf beiden entgegengesetzten Oberflächen der Hauptleiterplatte (2) in einer Weise montiert sind, dass das zweite IC-Gehäuse (6) genau im Rücken des ersten IC-Gehäuses (5) liegt, und wobei das erste IC-Gehäuse und das zweite IC-Gehäuse jeweils mit den entgegengesetzten Oberflächen der gedruckten Leiterplatte durch eine Plättchen-Verbindung verbunden sind, und wobei das erste IC-Gehäuse und das zweite IC-Gehäuse thermisch durch ein Durchgangsloch (33) miteinander verbunden sind, welches in einer Weise durch die Hauptleiterplatte (2) gebohrt ist, dass Wärme zwischen dem ersten IC-Gehäuse und dem zweiten IC-Gehäuse übertragen werden kann.

18. Vorrichtung nach Anspruch 17, wobei Leitungen (16, 18) des ersten IC-Gehäuses (5) und des zweiten IC-Gehäuses (6), welche jeweils auf einer der entgegengesetzten Seiten der Hauptleiterplatte montiert sind, mit einem wärmleitenden Harz (34) beschichtet sind.

## Revendications

1. Dispositif à semi-conducteur du type carte enfichable, comprenant une UC (10), un dispositif d'entrée/sortie (13) et une mémoire (9), qui sont montés sur des cartes à circuit imprimé, dans lequel les cartes à circuit imprimé comprennent :
une carte à circuit imprimé principale (2) ; et
une carte à circuit imprimé secondaire (3) raccordée électriquement à la carte à circuit imprimé principale par l'intermédiaire d'un circuit imprimé souple (4), dans lequel
la mémoire (9) comprend un élément de mémoire monté sur la carte à circuit imprimé secondaire (3).

2. Dispositif selon la revendication 1, dans lequel l'UC (10) est montée sur la carte à circuit imprimé principale (2).

3. Dispositif selon la revendication 1, dans lequel l'UC (10) est montée sur la carte à circuit imprimé secondaire (3).

4. Dispositif selon la revendication 1, dans lequel la carte à circuit imprimé secondaire (3) est placée de façon à faire face à la carte à circuit imprimé principale (2) en pliant le circuit imprimé souple (4), dans lequel le circuit imprimé souple est connecté à une surface de la carte à circuit imprimé principale, qui est opposée à son autre surface faisant face à la carte à circuit imprimé secondaire.

5. Dispositif selon la revendication 4, qui comprend en outre un moyen pour fixer intégralement la carte à circuit imprimé principale et la carte à circuit imprimé secondaire face à face.

6. Dispositif selon l'une quelconque des revendications 1 à 5, qui comprend en outre un boîtier (54) mince en forme de carte destiné à contenir la carte à circuit imprimé principale (2) et la carte à circuit imprimé secondaire (3), dans lequel au moins une surface du boîtier est constituée d'une plaque métallique (56) avançant vers l'extérieur par étirage.

7. Dispositif selon la revendication 1, qui comprend en outre un connecteur (8) dans lequel est disposé un grand nombre de bornes devant être connectées à un dispositif externe, dans lequel deux des bornes sont une borne de signal d'horloge point devant être connectée à un affichage à cristaux liquides extérieur et une borne de terre adjacente à la borne de signal d'horloge point.

8. Dispositif selon la revendication 1, qui comprend en outre un connecteur (8) dans lequel est disposée une pluralité de rangées comprenant un grand nombre de bornes devant être connectées à un dispositif externe, dans lequel trois des bornes d'une rangée de la pluralité de rangées sont une borne de signal R, une borne de signal G et une borne de signal B qui sont connectées à un affichage à cristaux liquides extérieur, dans lequel trois des bornes d'une autre rangée de la pluralité de rangées, qui est parallèle à ladite une rangée de la pluralité de rangées, sont une borne de signal de réaction R, une borne de signal de réaction G et une borne de signal de réaction B qui correspondent respectivement à la borne de signal R, à la borne de signal G et à la borne de signal B et sont placées dans des positions faisant face respectivement à la borne de signal R, à la borne de signal G et à la borne de signal B.

9. Dispositif selon la revendication 1, qui comprend en outre un connecteur (8) dans lequel est disposé un grand nombre de bornes devant être connectées à un dispositif externe, dans lequel le connecteur comprend un moyen pour diviser une rangée de bornes en portions horizontalement dissymétriques disposées le long de la rangée.

10. Dispositif selon la revendication 1, qui comprend en outre une deuxième carte à circuit imprimé secondaire (7) montée sur une surface de la carte à circuit imprimé principale (2), dans lequel une partie de circuit analogique est montée sur la deuxième carte à circuit imprimé secondaire, dans lequel une borne d'alimentation électrique de la deuxième carte à circuit imprimé secondaire est connectée en une position de la carte à circuit imprimé principale.

11. Dispositif selon la revendication 1, dans lequel un premier boîtier de circuit intégré (5) et un deuxième boîtier de circuit intégré (6) sont montés respectivement sur une première surface et une deuxième surface de la carte à circuit imprimé principale (2), et qui comprend en outre :
une première partie de connexion (A) pour connecter des fils (16) du premier boîtier de circuit intégré à des premières zones de bornes (17) formées sur la première surface ; et
une deuxième partie de connexion (A) pour connecter des fils du deuxième boîtier de circuit intégré à des deuxièmes zones de bornes (19) formées sur la deuxième surface, dans lequel la première surface est opposée à la deuxième surface, dans lequel le premier boîtier de circuit intégré (5) et le deuxième boîtier de circuit intégré (6) sont placés de telle façon que la deuxième partie de connexion située sur la deuxième surface se trouve juste au dos de la première partie de connexion située sur la première surface.

12. Dispositif selon la revendication 11, dans lequel la deuxième partie de connexion placée de façon à correspondre à un côté du deuxième boîtier de circuit intégré (6) est juste au dos de la première partie de connexion placée de façon à correspondre à un côté correspondant du premier boîtier de circuit intégré (5).

13. Dispositif selon la revendication 11, dans lequel la deuxième partie de connexion placée de façon à correspondre à chacun des quatre côtés du deuxième boîtier de circuit intégré (6) est juste au dos de la première partie de connexion placée de façon à correspondre à l'un des quatre côtés correspondants du premier boîtier de circuit intégré (5).

14. Dispositif selon la revendication 11, 12 ou 13, dans lequel les premier et deuxième boîtiers de circuit intégré (5, 6) sont équipés de puces de circuit intégré (10, 13) qui fonctionnent en liaison l'une avec l'autre.

15. Dispositif selon la revendication 14, dans lequel le premier boîtier de circuit intégré (5) est équipé de l'UC (10) et le deuxième boîtier de circuit intégré (6) est équipé du dispositif d'entrée/sortie (13) qui fonctionne en réponse à l'UC.

16. Dispositif selon la revendication 11, 12, 13, 14 ou 15, dans lequel le premier boîtier de circuit intégré (5) et/ou le deuxième boîtier de circuit intégré (6) est un boîtier pour mécanisme d'entraînement de bande.

17. Dispositif selon la revendication 1, comprenant en outre :
un premier boîtier de circuit intégré (5) ; et
un deuxième boîtier de circuit intégré (6), dans lequel le premier boîtier de circuit intégré et le deuxième boîtier de circuit intégré sont montés sur les deux surfaces opposées de la carte à circuit imprimé principale (2) de façon que le deuxième boîtier de circuit intégré (6) soit juste au dos du premier boîtier de circuit intégré (5), dans lequel le premier boîtier de circuit intégré et le deuxième boîtier de circuit intégré sont connectés respectivement sur les surfaces opposées de la carte à circuit imprimé, par une connexion de la puce, dans lequel le premier boîtier de circuit intégré et le deuxième boîtier de circuit intégré sont connectés thermiquement l'un à l'autre par l'intermédiaire d'un trou d'interconnexion (33) percé dans la carte à circuit imprimé principale (2) de façon que la chaleur puisse être transférée entre le premier boîtier de circuit intégré et le deuxième boîtier de circuit intégré.

18. Dispositif selon la revendication 17, dans lequel les fils (16, 18) du premier boîtier de circuit intégré (5) et du deuxième boîtier de circuit intégré (6) montés respectivement sur les côtés opposés de la carte à circuit imprimé principale sont recouverts d'une résine thermoconductrice (34).
